# EUROPEAN PATENT APPLICATION

(11) **EP 4 712 717 A1**
(43) Date of publication of application: **18.03.2026**
(21) Application number: 25192271.2
(22) Date of filing: 28.07.2025
(51) Int. Cl.: H10B 12/00

(54) **SEMICONDUCTOR MEMORY DEVICE**

(30) Priority: 13.09.2024 KR 20240126176
(71) Applicant: Samsung Electronics Co., Ltd., Suwon-si, Gyeonggi-do 16677 (KR)
(72) Inventor: LIM, Hanjin, 16677 Suwon-si (KR)
(74) Representative: Marks & Clerk LLP

(57) **Abstract**

A semiconductor memory device includes a substrate having an upper surface; an active region spaced apart from the substrate in a vertical direction that is perpendicular to the upper surface of the substrate, and extending in a first lateral direction that is parallel to the upper surface of the substrate; a word line at least partially surrounding the active region and extending in a second lateral direction that is parallel to the upper surface of the substrate and perpendicular to the first lateral direction; a capacitor including a first electrode connected to the active region; and an insulating loop protruding from the first electrode of the capacitor toward the word line in the first lateral direction, the insulating loop surrounding a portion of the active region and including a metal element.

## Description

### BACKGROUND

The present disclosure relates to a semiconductor memory device, and more particularly, to a semiconductor memory device including a plurality of memory cells arranged three-dimensionally.

Due to the development of electronics technology, the downscaling of semiconductor devices has rapidly progressed in recent years. Thus, the miniaturization of memory cells is required, and typical memory cells have limitations in maintaining high integration density and reliability. Accordingly, there is a need to develop a semiconductor memory device having a structure that facilitates miniaturization and high integration of memory cells.

Information in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

One or more example embodiments provide a semiconductor memory device having a structure that may be capable of maximizing the capacitance of a capacitor in a limited area by preventing the leaning or collapse of the capacitor.

Additional aspects will be set forth in part in the description which follows and, in part, will be apparent from the description, or may be learned by practice of the presented embodiments.

According to an aspect of an example embodiment, a semiconductor memory device includes: a substrate having an upper surface; an active region spaced apart from the substrate in a vertical direction that is perpendicular to the upper surface of the substrate, and extending in a first lateral direction that is parallel to the upper surface of the substrate; a word line at least partially surrounding the active region and extending in a second lateral direction that is parallel to the upper surface of the substrate and perpendicular to the first lateral direction; a capacitor including a first electrode connected to the active region; and an insulating loop protruding from the first electrode of the capacitor toward the word line in the first lateral direction, the insulating loop surrounding a portion of the active region and including a metal element.

According to an aspect of an example embodiment, a semiconductor memory device having a three-dimensional (3D) structure, includes: a substrate having an upper surface; and a memory cell block on the substrate, the memory cell block including: a plurality of active regions arranged in a line in a vertical direction that is perpendicular to the upper surface of the substrate; a plurality of word lines, each word line of the plurality of word lines at least partially surrounding a respective active region of the plurality of active regions and extending in a second lateral direction that is parallel to the upper surface of the substrate; a bit line extending in the vertical direction on the substrate, the bit line being connected to a first side of each active region of the plurality of active regions; a plurality of capacitors, each capacitor of the plurality of capacitors including a first electrode connected to a second side of a respective active region of the plurality of active regions, the second side being opposite to the first side; and a plurality of insulating loops arranged in a line in the vertical direction, each insulating loop of the plurality of insulating loops protruding from the first electrode of a respective capacitor of the plurality of capacitors toward a corresponding word line of the plurality of word lines in a first lateral direction that is parallel to the upper surface of the substrate and perpendicular to the second lateral direction, each insulating loop surrounding a portion of a respective active region of the plurality of active regions, wherein each insulating loop of the plurality of insulating loops includes a metal element.

According to an aspect of an example embodiment, a semiconductor memory device includes: a substrate having an upper surface; an active region extending in the first lateral direction that is parallel to the upper surface of the substrate and spaced apart from the substrate in a vertical direction that is perpendicular to the upper surface of the substrate, the active region including a channel region, a buried contact, and a direct contact, wherein the buried contact and the direct contact are spaced apart from each other in the first lateral direction with the channel region therebetween; a word line at least partially surrounding the channel region of the active region and extending in a second lateral direction that is parallel to the upper surface of the substrate and perpendicular to the first lateral direction; a gate dielectric film between the channel region of the active region and the word line; a bit line connected to the direct contact of the active region; a capacitor including a first electrode connected to the buried contact of the active region; a metal silicide film between the first electrode of the capacitor and the buried contact of the active region; and an insulating loop including a first portion contacting the first electrode of the capacitor, a second portion surrounding the metal silicide film, and a third portion surrounding a portion of the buried contact, the insulating loop including a metal element, wherein the gate dielectric film is aligned and collinear with the insulating loop in the first lateral direction.

At least some of the above and other features of the invention are set out in the claims.

### BRIEF DESCRIPTION OF THE DRAWINGS

The above and other aspects, features, and advantages of certain example embodiments of the present disclosure will be more apparent from the following description taken in conjunction with the accompanying drawings, in which:
FIG. 1 is a block diagram of a semiconductor memory device according to one or more embodiments;
FIG. 2 is a plan view of a semiconductor memory device according to one or more embodiments;
FIG. 3 is a cross-sectional view taken along line X1 - X1' of FIG. 2 according to one or more embodiments;
FIG. 4 is an enlarged cross-sectional view of a partial region "EX1" of FIG. 3 according to one or more embodiments;
FIG. 5 is a cross-sectional view taken along line Y1 - Y1' of FIG. 2 according to one or more embodiments;
FIG. 6A is an enlarged cross-sectional view taken along line Y2 - Y2' of FIG. 4, according to one or more embodiments;
FIG. 6B is an enlarged cross-sectional view taken along line Y3 - Y3' of FIG. 4 according to one or more embodiments;
FIG. 7 is a cross-sectional view of a semiconductor memory device according to one or more embodiments;
FIG. 8 is an enlarged cross-sectional view of a partial region "EX2" of FIG. 7 according to one or more embodiments;
FIG. 9 is an enlarged cross-sectional taken along line Y2 - Y2' of FIG. 8 according to one or more embodiments;
FIG. 10 is a cross-sectional view of a semiconductor memory device according to one or more embodiments;
FIGS. 11 to 36B are diagrams of a method of manufacturing a semiconductor memory device, according to one or more embodiments; and
FIGS. 37 to 39B are diagrams of a method of manufacturing a semiconductor memory device, according to one or more embodiments.

### DETAILED DESCRIPTION

Hereinafter, example embodiments of the disclosure will be described in detail with reference to the accompanying drawings. The same reference numerals are used for the same components in the drawings, and redundant descriptions thereof will be omitted. The embodiments described herein are example embodiments, and thus, the disclosure is not limited thereto and may be realized in various other forms.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c. As used herein, the singular forms "a", "an", and "the" are intended to include the plural forms as well, unless the context clearly indicates otherwise. Additionally, the description may be specific to a portion of the semiconductor memory device and the described structure may be repeated in other portions of the semiconductor memory device. For example, the described structure may be an individual element of an array of elements forming the semiconductor memory device. Accordingly, where the structure of a single element of a plurality of elements has been described, this structure may equally apply to other elements of the plurality of elements.

It will be understood that when an element or layer is referred to as being "over," "above," "on," "below," "under," "beneath," "connected to" or "coupled to" another element or layer, it can be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

As used herein, the term "cover" may indicate a full covering or a partial covering of a respective surface, and the term "surrounding" may indicate a full surrounding or a partial surrounding of a component, and variations thereof without specifically limiting the amount of covering or surrounding.

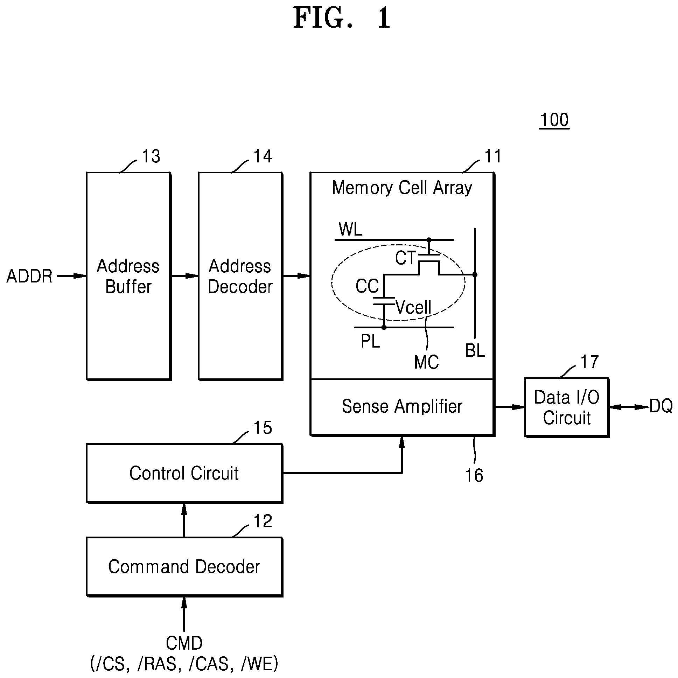

FIG. 1 is a block diagram of a semiconductor memory device 100 according to one or more embodiments.

Referring to FIG. 1, the semiconductor memory device 100 may include a memory cell array 11, a command decoder 12, an address buffer 13, an address decoder 14, a control circuit 15, a sense amplifier 16, and a data input/output (I/O) circuit 17.

The memory cell array 11 may include a plurality of memory cells MC. The memory cell array 11 may include a plurality of word lines WL, a plurality of bit lines BL, and a plurality of plate electrodes PL, which are connected to the memory cell MC. The memory cell array 11 may include dynamic random access memory (DRAM) configured to sense, as data, a cell voltage Vcell stored in the memory cell MC.

The semiconductor memory device 100 may receive and output data DQ from and to an external device, in response to a command CMD and an address ADDR, which are received from an external device (e.g., a central processing unit (CPU) or a memory controller).

Each of the plurality of memory cells MC may include a cell transistor CT and a cell capacitor CC. A gate of the cell transistor CT may be connected to the word line WL. A first terminal of the cell transistor CT may be connected to the bit line BL. A second terminal of the cell transistor CT may be connected to a first terminal of the cell capacitor CC. A second terminal of the cell capacitor CC may be connected to the plate electrode PL. The memory cell MC may store, in the cell capacitor CC, a cell voltage Vcell having a magnitude that specifies data.

The command decoder 12 may determine an input command CMD by referring to a chip select signal /CS, a row address strobe signal /RAS, a column address strobe signal /CAS, and a write enable signal /WE, which are applied from the external device. The command decoder 12 may generate control signals corresponding to the command CMD. The command CMD may include an active command, a read command, a write command, and a precharge command.

The address buffer 13 may receive an address ADDR applied from the external device. The address ADDR may include a word line address for addressing some of the plurality of word lines WL connected to the memory cell array 11, a bit line address for addressing some of the plurality of bit lines BL connected to the memory cell array 11, and a plate line address for addressing some of the plurality of plate electrodes PL connected to the memory cell array 11. The address buffer 13 may transmit each of the word line address, the bit line address, and the plate line address to the address decoder 14.

The address decoder 14 may include a word line decoder, a bit line decoder, and a plate line decoder, which are respectively configured to select the word line WL, the bit line BL, and the plate electrode PL of the memory cell MC to be accessed in response to the received address ADDR. The word line decoder may decode the word line address and activate the word line WL of the memory cell MC corresponding to the word line address. The bit line decoder may decode the bit line address and provide a bit line select signal for selecting the bit line BL of the memory cell MC corresponding to the bit line address. The plate line decoder may decode the plate line address and provide a plate line select signal for selecting the plate electrode PL of the memory cell MC corresponding to the plate line address.

The control circuit 15 may control the sense amplifier 16 under the control by the command decoder 12. The control circuit 15 may control an operation of the sense amplifier 16 to detect a cell voltage Vcell of the memory cell MC. The control circuit 15 may control the sense amplifier 16 to perform a precharge operation, a charge sharing operation, and a sense operation.

The sense amplifier 16 may detect charges stored in the memory cell MC as data. Also, the sense amplifier 16 may transmit detected data DQ to the data I/O circuit 170 such that the detected data DQ is output to the outside of the semiconductor memory device 100.

The data I/O circuit 17 may receive data DQ to be written to the memory cell MC from the outside and transmit the data DQ to the memory cell array 11. The data I/O circuit 17 may output bit data detected by the sense amplifier 16 as read data to the outside.

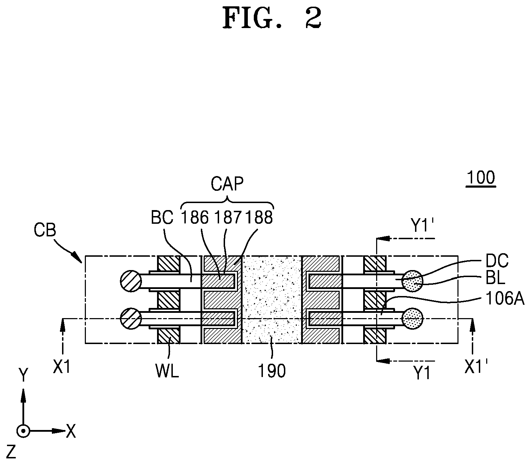

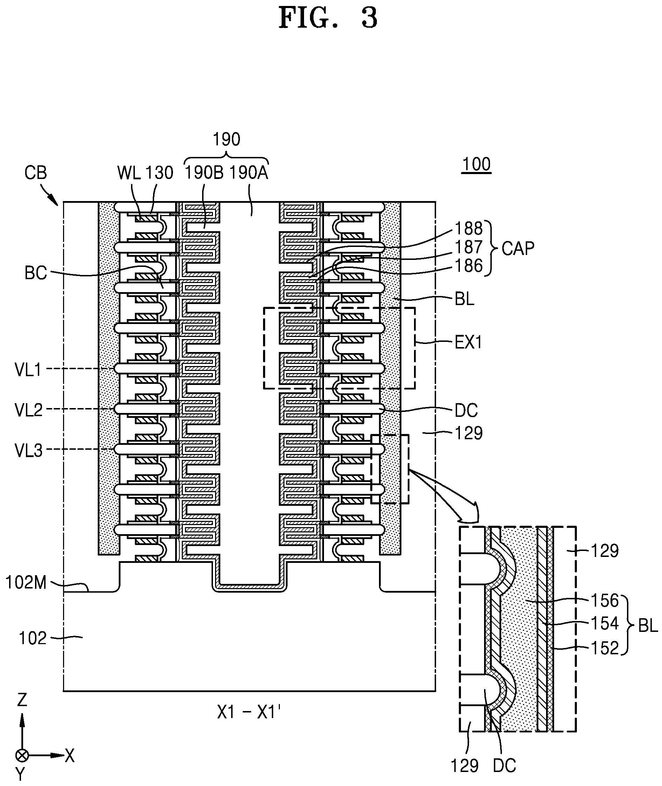

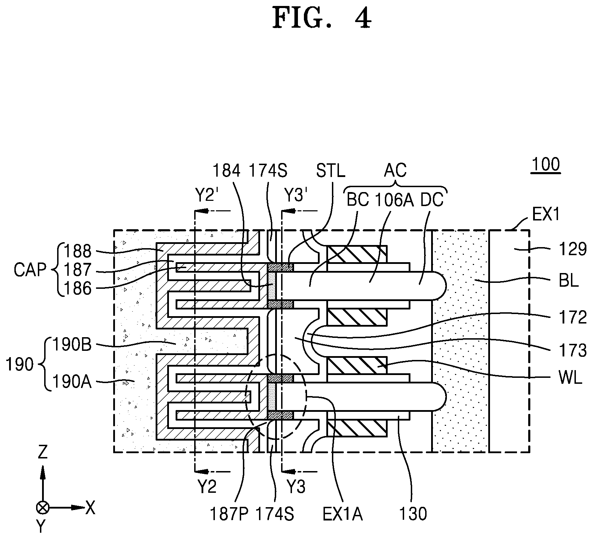

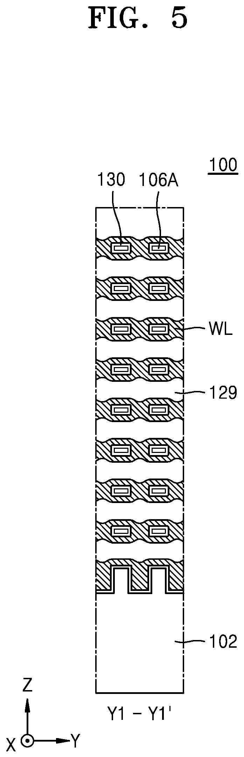

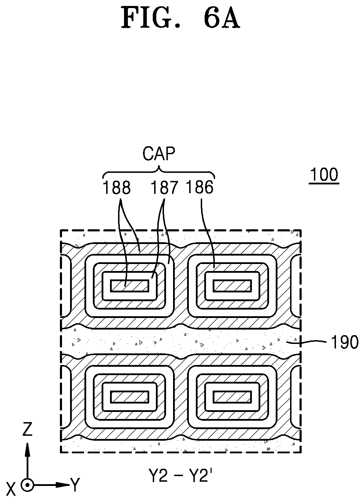

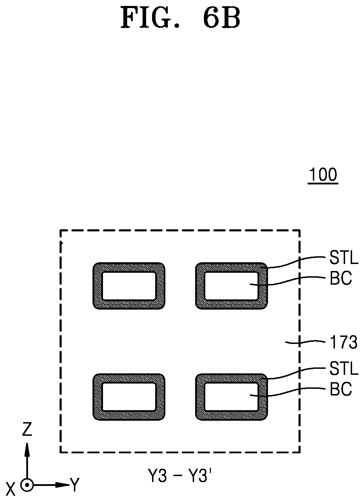

FIGS. 2 to 6B are diagrams of a semiconductor memory device 100 according to one or more embodiments. More specifically, FIG. 2 is a plan view of the semiconductor memory device 100 according to one or more embodiments. FIG. 3 is a cross-sectional view taken along line X1 - X1' of FIG. 2. FIG. 4 is an enlarged cross-sectional view of a partial region "EX1" of FIG. 3. FIG. 5 is a cross-sectional view taken along line Y1 - Y1' of FIG. 2. FIG. 6A is an enlarged cross-sectional view taken along line Y2 - Y2' of FIG. 4. FIG. 6B is an enlarged cross-sectional view taken along line Y3 - Y3' of FIG. 4. Components of the semiconductor memory device 100 described below with reference to FIGS. 2 to 6B may constitute a portion of the memory cell array 11 described with reference to FIG. 1.

Referring to FIGS. 2 to 6B, the semiconductor memory device 100 may include a memory cell block CB including a plurality of memory cells, which are repeatedly arranged on a substrate 102 in a first lateral direction (X direction) and a second lateral direction (Y direction), which are perpendicular to each other, and a vertical direction (Z direction), which is perpendicular to a upper surface 102M of the substrate 102. The first and second lateral directions may be parallel to the upper surface 102M of the substrate 102. The upper surface 102M of the substrate 102 may be a surface upon which the plurality of memory cells are arranged. The vertical direction may define a height direction. Accordingly, features that are "above" other features may be located further along the vertical direction than the other features. It will be appreciated that the directions and positions defined herein are defined relative to the structure of the semiconductor memory device 100, and therefore need not imply any particular orientation of the semiconductor memory device 100, in use.

At each of a plurality of vertical levels spaced apart from the substrate 102 in the vertical direction (Z direction), such as vertical level VL1, vertical level VL2, vertical level VL3 of FIG. 3, the memory cell block CB may include a plurality of active regions AC, which are repeatedly arranged in the first lateral direction (X direction) and the second lateral direction (Y direction). As shown in FIG. 3, the plurality of active regions AC included in the memory cell block CB may include a plurality of active regions AC, which are arranged in a line in the vertical direction (Z direction) on the substrate 102 and are positioned over each other in the vertical direction (Z direction). In one or more embodiments, as shown in FIGS. 3 and 4, each of the plurality of active regions AC included in the memory cell block CB may have a thickness in the vertical direction (Z direction), which is constant in the first lateral direction (X direction).

Each of the plurality of active regions AC may include a channel region 106A and a buried contact BC and a direct contact DC, which are spaced apart from each other in the first lateral direction (X direction) with the channel region 106A therebetween. In each of the plurality of active regions AC, the buried contact BC, the channel region 106A, and the direct contact DC may be sequentially arranged in a straight line in the first lateral direction (X direction). In one or more embodiments, each of the plurality of active regions AC may have a height in the vertical direction (Z direction), which is substantially constant in the first lateral direction (X direction). In the plurality of active regions AC, respective heights of the buried contact BC, the channel region 106A, and the direct contact DC in the vertical direction (Z direction) may be the same as each other or similar to each other. In one or more embodiments, each of the plurality of active regions AC may include a doped Si layer.

As shown in FIGS. 2, 3, and 4, at each of a plurality of vertical levels that are spaced apart from the substrate 102 in the vertical direction (Z direction), the memory cell block CB of the semiconductor memory device 100 may include a plurality of word lines WL, which extend lengthwise in the second lateral direction (Y direction) that is parallel to the upper surface 102M of the substrate 102. The plurality of word lines WL may be spaced apart from each other in the first lateral direction (X direction), the second lateral direction (Y direction), and the vertical direction (Z direction). Each of the plurality of word lines WL may at least partially surround a corresponding active region AC. Each of the plurality of word lines WL may surround a channel region 106A, which is a local region of one of the plurality of active regions AC included in the memory cell block CB, and extend lengthwise in the second lateral direction (Y direction). Each of the plurality of word lines WL may extend across a top surface and a bottom surface of a corresponding channel region 106A. Each of the plurality of word lines WL may extend across side surfaces in the second lateral direction (Y direction) of the corresponding channel region 106A. As shown in FIG. 3, the plurality of word lines WL included in the memory cell block CB may be arranged in a line in the vertical direction (Z direction) on the substrate 102 and are positioned over each other in the vertical direction (Z direction).

In one or more embodiments, each of the plurality of word lines WL may include a metal, a conductive metal nitride, a metal silicide, doped polysilicon, or a combination thereof. For example, each of the plurality of word lines WL may include titanium (Ti), titanium nitride (TiN), tantalum (Ta), tantalum nitride (TaN), molybdenum (Mo), ruthenium (Ru), tungsten (W), tungsten nitride (WN), cobalt (Co), aluminum (Al), nickel (Ni), titanium silicide (TiSi), titanium silicon nitride (TiSiN), tungsten silicide (WSi), tungsten silicon nitride (WSiN), tantalum silicide (TaSi), tantalum silicon nitride (TaSiN), ruthenium titanium nitride (RuTiN), cobalt silicide (CoSi), nickel silicide (NiSi), doped polysilicon, or a combination thereof, without being limited thereto.

A gate dielectric film 130 may be between the channel region 106A of the active region AC and the word line WL. In the first lateral direction (X direction), a width of each of the plurality of gate dielectric films 130 may be greater than a width of each of the plurality of word lines WL. In one or more embodiments, the gate dielectric film 130 may include a paraelectric material. For example, the gate dielectric film 130 may include silicon oxide, silicon nitride, silicon oxynitride, or a combination thereof. In one or more embodiments, the gate dielectric film 130 may include a high-k dielectric material. The high-k dielectric material may have a dielectric constant that is greater than that of silicon oxide. For instance, the high-k dielectric material may have a dielectric constant of about 10 to about 25. For example, the high-k dielectric material may include hafnium oxide, aluminum oxide, zirconium oxide, or a combination thereof, without being limited thereto. For instance, each of the plurality of gate dielectric films 130 may include HfO₂, Al₂O₃, ZrO₂, or a combination thereof, without being limited thereto. In still one or more embodiments, the gate dielectric film 130 may include a combination of a paraelectric material and a high-k dielectric material.

As shown in FIGS. 3 and 4, respective spaces of the plurality of word lines WL arranged in a line in the vertical direction (Z direction) may be filled by an insulating structure 129. The insulating structure 129 may include a silicon oxide film, a silicon nitride film, or a combination thereof.

As shown in FIGS. 2 to 4, the memory cell block CB of the semiconductor memory device 100 may include a plurality of bit lines BL, which extend lengthwise in the vertical direction (Z direction). On the substrate 102, each of the plurality of bit lines BL may pass through the insulating structure 129 and extend lengthwise in the vertical direction (Z direction). Each of the plurality of bit lines BL may be connected to one end of each of the plurality of active regions AC that and are positioned over each other in the vertical direction (Z direction), from among the plurality of active regions AC included in the memory cell block CB. Each of the plurality of bit lines BL may be connected to the direct contact DC of one of the plurality of active regions AC.

In one or more embodiments, the direct contact DC included in the active region AC may include a doped silicon layer. For example, the direct contact DC may include a silicon layer doped with an n-type dopant. Each of the plurality of bit lines BL may include a metal, a conductive metal nitride, a metal silicide, doped polysilicon, or a combination thereof. For example, each of the plurality of bit lines BL may include Ti, TiN, Ta, TaN, Mo, Ru, W, WN, Co, Al, Ni, TiSi, TiSiN, WSi, WSiN, TaSi, TaSiN, RuTiN, CoSi, NiSi, doped polysilicon, or a combination thereof, without being limited thereto. In one or more embodiments, as shown in FIG. 3, each of the plurality of bit lines BL may include a metal silicide film 152, a conductive liner 154, and a conductive plug 156, which are sequentially stacked on a surface of the direct contact DC of the active region AC. When viewed in an X-Y plane of FIG. 3, the conductive plug 156 may be surrounded by the conductive liner 154, and the conductive plug 156 and the conductive liner 154 may be surrounded by the metal silicide film 152. In one or more embodiments, the metal silicide film 152 may be omitted. In one or more embodiments, the metal silicide film 152 may include molybdenum silicide or titanium silicide, the conductive liner 154 may include TiN, and the conductive plug 156 may include W, without being limited thereto.

As shown in FIGS. 2, 3, and 4, the memory cell block CB of the semiconductor memory device 100 may include a plurality of capacitors CAP respectively connected to the plurality of active regions AC. Each of the plurality of capacitors CAP may include a first electrode 186, a dielectric film 187, and a second electrode 188. The first electrode 186 of the capacitor CAP may be connected to the buried contact BC of one of the plurality of active regions AC.

As shown in FIGS. 3 and 4, a metal silicide film 184 may be between the first electrode 186 of the capacitor CAP and the buried contact BC of the active region AC. The metal silicide film 184 may include titanium silicide, tantalum silicide, cobalt silicide, molybdenum silicide, or tungsten silicide, without being limited thereto. The first electrode 186 of the capacitor CAP may be electrically connected to the buried contact BC of the active region AC through the metal silicide film 184. In one or more embodiments, the metal silicide film 184 may be omitted. In this case, the first electrode 186 of the capacitor CAP may contact the buried contact BC of the active region AC. The second electrode 188 of the capacitor CAP may be spaced apart from the active region AC and cover a surface of the first electrode 186. The dielectric film 187 of the capacitor CAP may be between the first electrode 186 and the second electrode 188.

As shown in FIG. 2, in a view from above, the plurality of capacitors CAP may be adjacent to the plurality of word lines WL and the plurality of active regions AC, and may be arranged in a line in the second lateral direction (Y direction). As used herein, the view from above may indicate a view from the X-Y plane. In a view from above, each of the plurality of active regions AC may be between the bit line BL and the capacitor CAP, each of which is adjacent thereto, in the first lateral direction (X direction). As shown in FIGS. 2 and 3, the plurality of bit lines BL may be spaced apart from the plurality of capacitors CAP in the first lateral direction (X direction) with the plurality of word lines WL therebetween.

In each of the plurality of capacitors CAP, each of the first electrode 186 and the second electrode 188 may include a metal film, a conductive metal oxide film, a conductive metal nitride film, a conductive metal oxynitride film, or a combination thereof. In one or more embodiments, each of the first electrode 186 and the second electrode 188 may include molybdenum (Mo), tungsten (W), ruthenium (Ru), platinum (Pt), iridium (Ir), cobalt (Co), tin (Sn), titanium (Ti), a Ti nitride, a Ti oxide, a Ti oxynitride, niobium (Nb), a Nb nitride, a Nb oxide, a Nb oxynitride, a tungsten (W) nitride, a vanadium (V) nitride, a V oxide, a molybdenum (Mo) nitride, a molybdenum (Mo) oxide, a ruthenium (Ru) oxide, a strontium ruthenium (SrRu) oxide, a cobalt (Co) nitride, a Co oxide, a Co oxynitride, a tin (Sn) nitride, a Sn oxide, a Sn oxynitride, or a combination thereof. For example, each of the first electrode 186 and the second electrode 188 may include titanium nitride (TiN), niobium nitride (NbN), cobalt nitride (CoN), tin oxide (SnO₂), or a combination thereof. In one or more embodiments, each of the first electrode 186 and the second electrode 188 may include tantalum nitride (TaN), titanium aluminum nitride (TiAlN), tantalum aluminum nitride (TaAlN), vanadium (V), vanadium nitride (VN), molybdenum (Mo), molybdenum nitride (MoN), tungsten (W), tungsten nitride (WN), ruthenium (Ru), ruthenium oxide (RuO₂), strontium ruthenium oxide (SrRuO₃, SRO), iridium (Ir), iridium oxide (IrO₂), platinum (Pt), platinum oxide (PtO), (Ba,Sr)RuO₃ (BSRO), CaRuO₃ (CRO), (La,Sr)CoO₃) (LSCo), or a combination thereof. However, a constituent material of each of the first electrode 186 and the second electrode 188 is not limited to the examples described above.

The dielectric film 187 may include a silicon oxide film, a high-k dielectric film, or a combination thereof. In one or more embodiments, the dielectric film 187 may include a metal oxide including at least one metal among hafnium (Hf), zirconium (Zr), aluminum (Al), niobium (Nb), cerium (Ce), lanthanum (La), tantalum (Ta), and titanium (Ti). In one or more embodiments, the dielectric film 187 may have a single film structure including one high-k dielectric film. In one or more embodiments, the dielectric film 187 may have a multilayered structure including a plurality of high-k dielectric films sequentially stacked on the first electrode 186. The high-k dielectric films may include a HfO₂ film, a ZrO₂ film, an Al₂O₃ film, a Y₂O₃ film, a Sc₂O₃ film, a La₂O₃ film, a Ta₂O₅ film, a Nb₂O₅ film, a CeO₂ film, a TiO₂ film, a GeO₂ film, a SrTiO₃ film, a BaSrTiO₃ film, or a combination thereof, without being limited thereto. In one or more embodiments, the dielectric film 187 may include an oxide of at least one metal from among Ti, Nb, Ta, Sn, and Mo or an oxynitride of at least one metal from among Ti, Nb, Ta, Sn, and Mo. For example, the dielectric film 187 may include a Ti oxide, a Ti oxynitride, a Nb oxide, a Nb oxynitride, a Ta oxide, a Ta oxynitride, a Sn oxide, a Sn oxynitride, a Mo oxide, a Mo oxynitride, and a combination thereof. In still one or more embodiments, the dielectric film 187 may include a ferroelectric film, which includes at least one oxide from among hafnium (Hf), silicon (Si), aluminum (Al), zirconium (Zr), yttrium (Y), lanthanum (La), gadolinium (Gd), and strontium (Sr). The ferroelectric film may include a hafnium-based oxide, for example, hafnium oxide (HfO), hafnium zirconium oxide (HZO), hafnium titanium oxide, and hafnium silicon oxide. The ferroelectric film may further include a dopant as needed. The dopant may include at least one element from among silicon (Si), aluminum (Al), zirconium (Zr), yttrium (Y), lanthanum (La), gadolinium (Gd), scandium (Sc), strontium (Sr), magnesium (Mg), and barium (Ba), without being limited thereto.

As shown in FIGS. 3, 4, and 6A, the first electrode 186 of each of the plurality of capacitors CAP may have a cylindrical shape defining an inner space that accommodates a portion of the dielectric film 187 and a portion of the second electrode 188. The dielectric film 187 may cover an inner surface and an outer surface of the first electrode 186. As shown in FIG. 6A, when viewed in a Y-Z plane, a cross-section of the first electrode 186 may have a rectangular closed loop shape with round corners. The dielectric film 187 may contact each of the inner surface and the outer surface of the first electrode 186. A portion of the second electrode 188 may fill a portion defined by the dielectric film 187 in an inner space of the first electrode 186, and another portion of the second electrode 188 may cover the outer surface of the first electrode 186 with the dielectric film 187 therebetween.

As shown in FIGS. 3 and 4, the memory cell block CB of the semiconductor memory device 100 may include a plurality of metal-containing insulating loops STL. In the memory cell block CB of the semiconductor memory device 100, the plurality of metal-containing insulating loops STL may be arranged in a line in the vertical direction (Z direction).

Each of the plurality of metal-containing insulating loops STL may protrude from the first electrode 186 of one of the plurality of capacitors CAP toward a corresponding one of the plurality of word lines WL and the gate dielectric film 130 adjacent thereto in the first lateral direction (X direction). Each of the plurality of metal-containing insulating loops STL may surround the buried contact BC, which is a portion of one of the plurality of active regions AC. As shown in FIG. 6B, when viewed in a Y-Z plane, a cross-section of each of the plurality of metal-containing insulating loops STL may have a rectangular closed loop shape with round corners.

As shown in FIG. 4, each of the plurality of metal-containing insulating loops STL may include a first portion contacting the first electrode 186 of the capacitor CAP, a second portion surrounding the metal silicide film 184, and a third portion surrounding a portion of the buried contact BC. One of the plurality of gate dielectric films 130 may be aligned and collinear with one of the plurality of metal-containing insulating loops STL in the first lateral direction (X direction). The metal silicide film 184 may be surrounded by one of the plurality of metal-containing insulating loops STL, and an outer surface of the metal silicide film 184 may be in contact with the selected one of the plurality of metal-containing insulating loops STL.

As specifically shown in FIG. 4, the dielectric film 187 of the capacitor CAP may have a surface contacting the metal-containing insulating loop STL. The semiconductor memory device 100 may include an insulating liner 172 surrounding the buried contact BC, a buried insulating film 173 surrounding the insulating liner 172 and the metal-containing insulating loop STL, and an oxide liner 174S covering a surface facing the dielectric film 187 and the second electrode 188, from among surfaces of the buried insulating film 173. The insulating liner 172 may surround the buried contact BC and contact a surface closest to the word line WL and the gate dielectric film 130, from among surfaces of the metal-containing insulating loop STL, in the first lateral direction (X direction). The insulating liner 172 may cover a sidewall of the word line WL. A portion of the insulating liner 172, which surrounds the buried contact BC, may be collinear with the metal-containing insulating loop STL in the first lateral direction (X direction). In one or more embodiments, each of the insulating liner 172 and the oxide liner 174S may include silicon oxide, and the buried insulating film 173 may include silicon nitride, without being limited thereto.

The oxide liner 174S may surround at least a portion of the metal-containing insulating loop STL. In the first lateral direction (X direction), a width of the oxide liner 174S may be less than a width of the metal-containing insulating loop STL. As can be seen in portion "EX1A" illustrated with a dashed line in FIG. 4, the dielectric film 187 may include a protrusion 187P protruding toward the word line WL and the gate dielectric film 130 in the first lateral direction (X direction). The protrusion 187P of the dielectric film 187 may be between the oxide liner 174S and the metal-containing insulating loop STL. The protrusion 187P of the dielectric film 187 may contact each of the oxide liner 174S and the metal-containing insulating loop STL. Of the oxide liner 174S, at least a portion of a surface facing the metal-containing insulating loop STL may be spaced apart from the metal-containing insulating loop STL in the vertical direction (Z direction) with the protrusion 187P of the dielectric film 187 therebetween.

In one or more embodiments, each of the plurality of metal-containing insulating loops STL may include a crystallized metal oxide. For example, each of the plurality of metal-containing insulating loops STL may include HfO₂, ZrO₂, Ta₂O₅, Nb₂O₅, TiO₂, La₂O₃, or a combination thereof, without being limited thereto.

Each of the dielectric film 187 of the capacitor CAP and the metal-containing insulating loop STL may include a metal oxide. In this case, in one or more embodiments, the dielectric film 187 of the capacitor CAP may include a metal element of the same type as a metal element included in the metal-containing insulating loop STL. For example, when the metal-containing insulating loop STL includes HfO₂, the dielectric film 187 may include a hafnium oxide film, for example, a HfO₂ film.

As shown in FIGS. 2 and 3, the memory cell block CB of the semiconductor memory device 100 may further include a plate electrode 190. The plate electrode 190 may correspond to the plate electrode PL described with reference to FIG. 1. As shown in FIG. 3, the plate electrode 190 may include a center portion 190A and a plurality of finger portions 190B. The center portion 190A may extend lengthwise in the vertical direction (Z direction) on the substrate 102. The plurality of finger portions 190B may protrude from the center portion 190A in the first lateral direction (X direction). Each of the plurality of finger portions 190B of the plate electrode 190 may overlap the first electrode 186 of the capacitor CAP in the vertical direction (Z direction). The plurality of finger portions 190B of the plate electrode 190 may be spaced apart from the first electrode 186 of the capacitor CAP in the vertical direction (Z direction) with the dielectric film 187 and the second electrode 188 of the capacitor CAP therebetween. A plurality of capacitors CAP located on both sides of one plate electrode 190 in the first lateral direction (X direction) may share the one plate electrode 190. The plurality of capacitors CAP and the memory cells on both sides of the one plate electrode 190 may be symmetrical about the plate electrode 190 (e.g. about an axis of symmetry running in the second lateral direction (X direction) and passing through a center of the plate electrode 190). The plate electrode 190 may include a metal film, a conductive metal oxide film, a conductive metal nitride film, a conductive metal oxynitride film, semiconductor film, or a combination thereof. In one or more embodiments, the plate electrode 190 may include Ti, a Ti nitride, a Ti oxide, a Ti oxynitride, Nb, a Nb nitride, a Nb oxide, a Nb oxynitride, Co, a Co nitride, a Co oxide, a Co oxynitride, Sn, a Sn nitride, a Sn oxide, a Sn oxynitride, silicon germanium (SiGe), or a combination thereof. For example, the plate electrode 190 may include titanium nitride (TiN), niobium nitride (NbN), tantalum nitride (TaN), titanium aluminum nitride (TiAlN), tantalum aluminum nitride (TaAlN), vanadium (V), vanadium nitride (VN), molybdenum (Mo), molybdenum nitride (MoN), tungsten (W), tungsten nitride (WN), ruthenium (Ru), iridium (Ir), platinum (Pt), silicon germanium (SiGe), or a combination thereof, without being limited thereto.

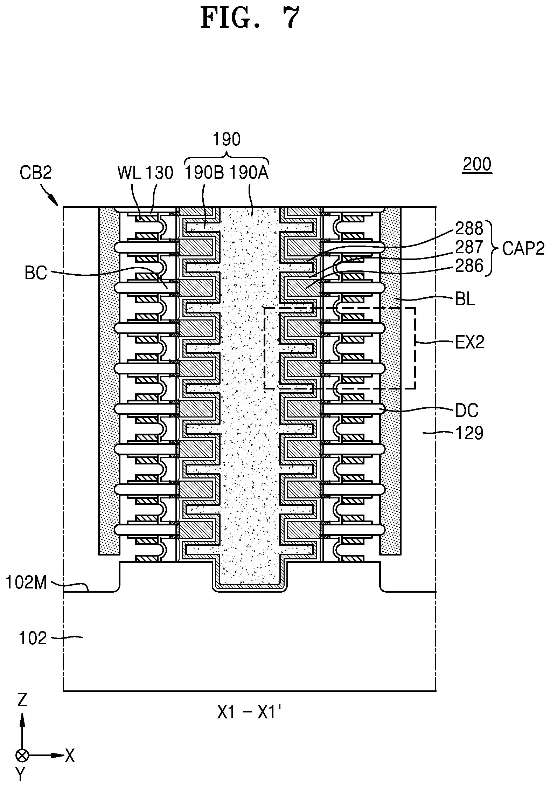

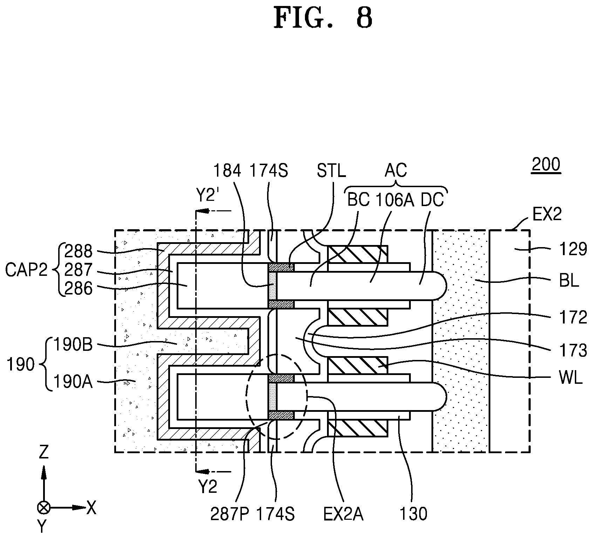

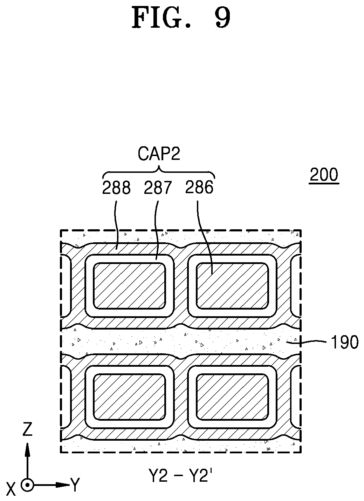

FIGS. 7 to 9 are diagrams of a semiconductor memory device 200 according to one or more embodiments. More specifically, FIG. 7 is a cross-sectional view of a portion of the semiconductor memory device 200, which corresponds to a cross-section taken along line X1-X1' of FIG. 2. FIG. 8 is an enlarged cross-sectional view of a partial region "EX2" of FIG. 7. FIG. 9 is an enlarged cross-sectional view along line Y2 - Y2' of FIG. 8. Components of the semiconductor memory device 200 described below with reference to FIGS. 7 to 9 may constitute a portion of the memory cell array 11 described with reference to FIG. 1. In FIGS. 7 to 9, the same reference numerals are used to denote the same elements as in FIGS. 2 to 6B, and thus, repeated descriptions thereof may be omitted.

Referring to FIGS. 7 to 9, a memory cell block CB2 of the semiconductor memory device 200 may substantially have the same configuration as the memory cell block CB of the semiconductor memory device 100, which has been described with reference to FIGS. 2 to 6B. However, the memory cell block CB2 of the semiconductor memory device 200 may include a plurality of capacitors CAP2 respectively connected to a plurality of active regions AC. Each of the plurality of capacitors CAP2 may include a first electrode 286, a dielectric film 287, and a second electrode 288. The first electrode 286 of the capacitor CAP2 may be connected to a buried contact BC of one of the plurality of active regions AC. The first electrode 286, the dielectric film 287, and the second electrode 288 of each of the plurality of capacitors CAP2 may respectively and substantially have the same configurations as the first electrode 186, the dielectric film 187, and the second electrode 188, which have been described with reference to FIGS. 2 to 4. However, the first electrode 286 of each of the plurality of capacitors CAP2 may have a pillar shape with filled interior.

As can be seen in portion "EX2A" illustrated with a dashed line in FIG. 8, the dielectric film 287 may include a protrusion 287P protruding toward a word line WL and a gate dielectric film 130 in a first lateral direction (X direction). The protrusion 287P of the dielectric film 287 may be between an oxide liner 174S and a metal-containing insulating loop STL. The protrusion 287P of the dielectric film 287 may contact each of the oxide liner 174S and the metal-containing insulating loop STL. Of the oxide liner 174S, at least a portion of a surface facing the metal-containing insulating loop STL may be spaced apart from the metal-containing insulating loop STL in a vertical direction (Z direction) with the protrusion 287P of the dielectric film 287 therebetween.

As shown in FIG. 9, when viewed in a Y-Z plane, a cross-section of the first electrode 286 may have a rectangular shape with round corners. The dielectric film 287 may be in contact with an outer surface of the first electrode 286. The second electrode 288 may cover the outer surface of the first electrode 286 with the dielectric film 287 therebetween.

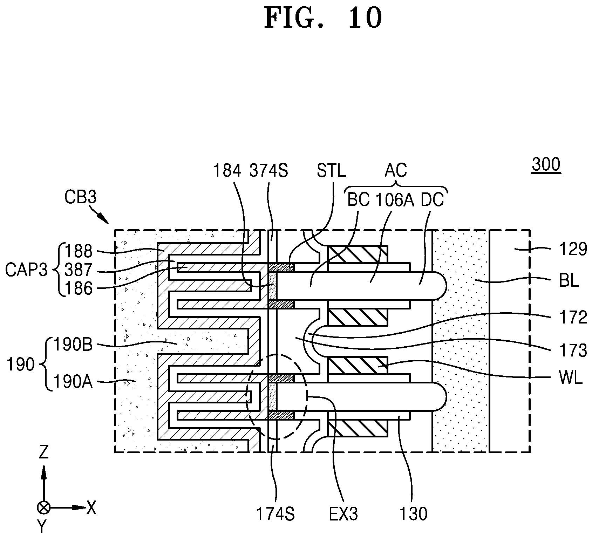

FIG. 10 is a cross-sectional view of a semiconductor memory device 300 according to one or more embodiments. FIG. 10 illustrates a cross-sectional configuration of a portion of the semiconductor memory device 300, which corresponds to a cross-section taken along line X1-X1' of FIG. 2. Components of the semiconductor memory device 300 described below with reference to FIG. 10 may constitute a portion of the memory cell array 11 described with reference to FIG. 1. In FIG. 10, the same reference numerals are used to denote the same elements as in FIGS. 2 to 6B, and thus, repeated descriptions thereof may be omitted.

Referring to FIG. 10, a memory cell block CB3 of the semiconductor memory device 300 may substantially have the same configuration as the memory cell block CB of the semiconductor memory device 100, which has been described with reference to FIGS. 2 to 6B. However, the memory cell block CB3 of the semiconductor memory device 300 may include an oxide liner 374S covering a surface of the buried insulating film 173 facing a dielectric film 387 and a second electrode 188, and a plurality of capacitors CAP3 respectively connected to a plurality of active regions AC.

In the memory cell block CB3 of the semiconductor memory device 300, each of the plurality of capacitors CAP3 may include a first electrode 186, the dielectric film 387, and the second electrode 188. Detailed configurations of the first electrode 186 and the second electrode 188 of the capacitor CAP3 may be the same as those described with reference to FIGS. 2, 3, and 6A. The dielectric film 387 of the capacitor CAP3 may substantially have the same configuration as the dielectric film 187 described with reference to FIGS. 2, 3, and 6A. However, the dielectric film 387 of the capacitor CAP3 may not include a portion protruding between the oxide liner 374S and a metal-containing insulating loop STL. The oxide liner 374S may at least partially surround the metal-containing insulating loop STL. In a first lateral direction (X direction), a width of the oxide liner 374S may be less than a width of the metal-containing insulating loop STL. The oxide liner 374S may include silicon oxide, without being limited thereto.

As can be seen in portion "EX3" illustrated with a dashed line in FIG. 10, a surface of the oxide liner 374S, which faces the metal-containing insulating loop STL, may contact an outer surface of the metal-containing insulating loop STL.

The semiconductor memory devices 100, 200, and 300 described with reference to FIGS. 1 to 10 may include the metal-containing insulating loop STL, which protrudes from the first electrodes 186 and 286 of the capacitors CAP, CAP2, and CAP3 in the first lateral direction (X direction) and surrounds a portion of a buried contact BC of the active region AC. The metal-containing insulating loop STL may be advantageous in controlling effective lengths of the first electrodes 186 and 286 to a constant level during the processes of manufacturing the semiconductor memory devices 100, 200, and 300. Therefore, the semiconductor memory devices 100, 200, and 300 according to one or more embodiments may provide a structure capable of maximizing the capacitances of the capacitors CAP, CAP2, and CAP3 even when an area occupied by a plurality of memory cells arranged three-dimensionally is reduced due to the miniaturization and high integration of the plurality of memory cells. In addition, the semiconductor memory devices 100, 200, and 300 according to one or more embodiments may have improved performance without inefficiently increasing the area occupied by the plurality of memory cells in the memory cell blocks CB, CB2, and CB3, and provide a structure that is advantageous for high integration.

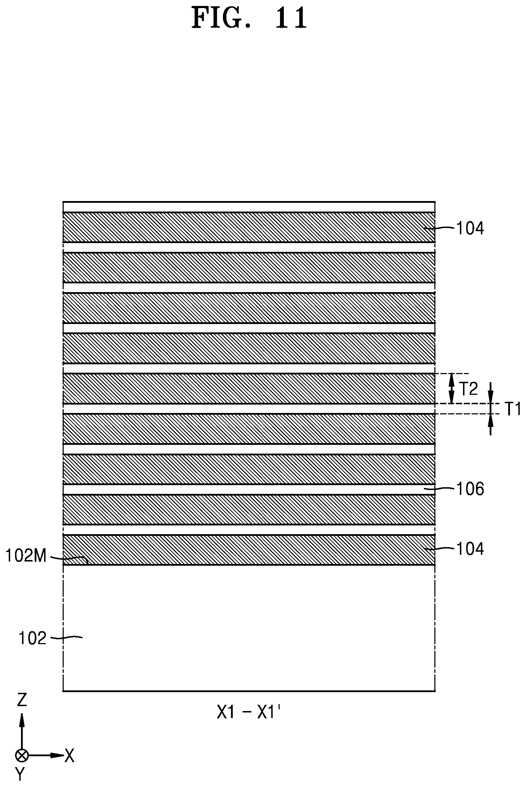

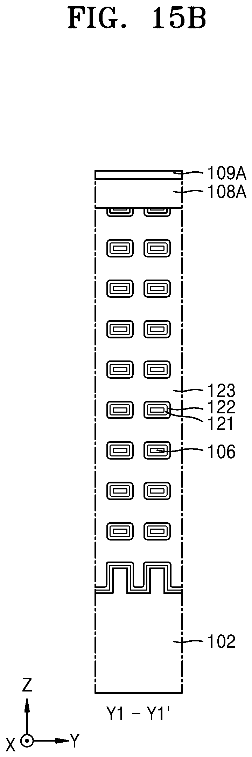

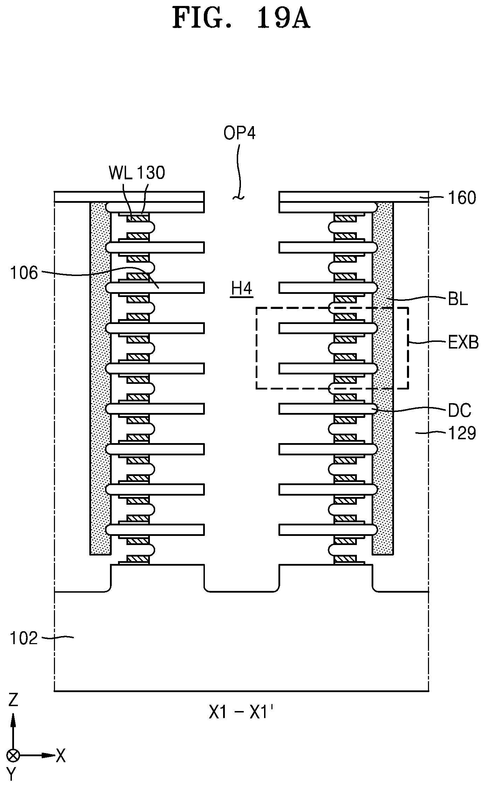

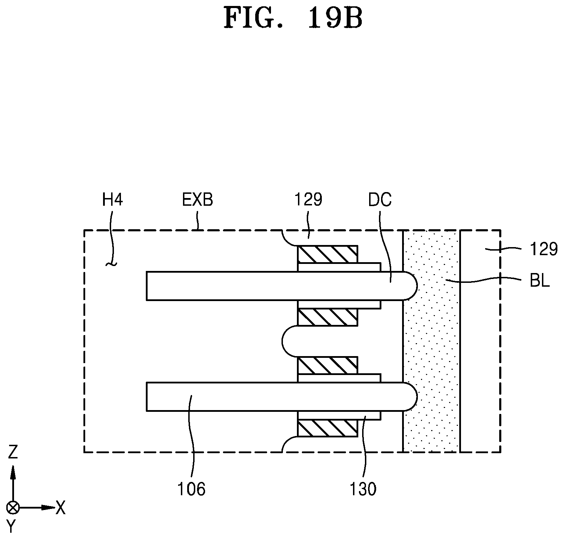

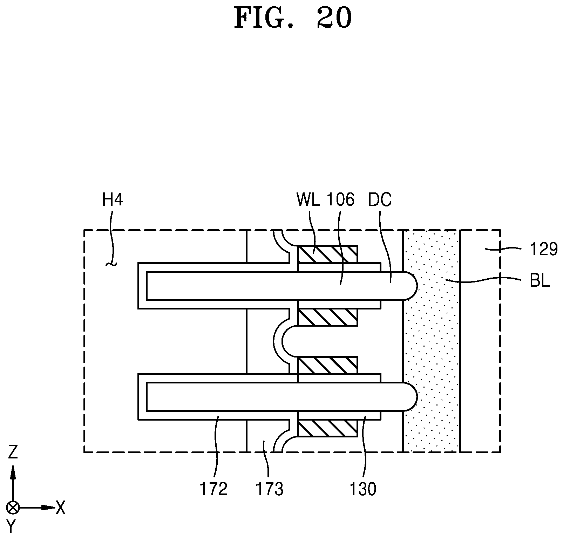

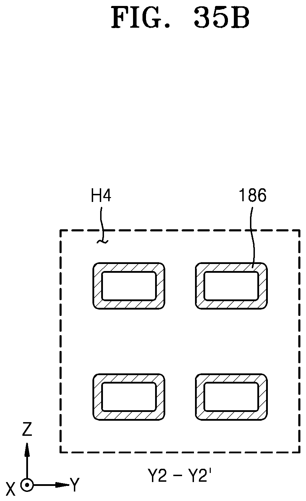

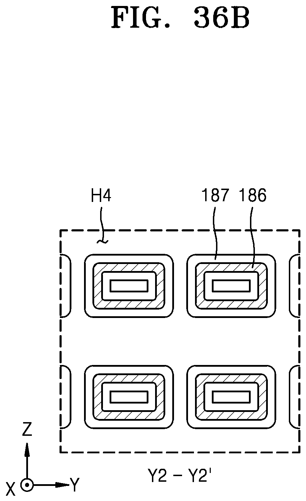

FIGS. 11 to 36B are diagrams of a method of manufacturing a semiconductor memory device, according to one or more embodiments. More specifically, FIGS. 11, 12, 13, 14, 15A, 16A, 17A, 18, and 19A are each a cross-sectional view of a partial region corresponding to a cross-section taken along line X1 - X1' of FIG. 2, according to a process sequence. FIGS. 15B, 16B, and 17B are each a cross-sectional view of a partial region corresponding to a cross-section taken along line Y1 - Y1' of FIG. 2. FIG. 19B is an enlarged cross-sectional view of a partial region "EXB" of FIG. 19A. FIGS. 20, 21, 22, 23, 24, 25, 26, 27, 28, 29, 30, 31, 32, 33, 34, 35A, and 36A are each an enlarged cross-sectional view of an example of a region corresponding to the partial region "EX1" of FIG. 3, according to the process sequence. FIGS. 35B and 36B are each a cross-sectional view of an example of a partial region corresponding to a cross-section taken along line Y2-Y2' of FIG. 4, according to the process sequence. An example of a method of manufacturing the semiconductor memory device 100 described with reference to FIGS. 2 to 6B is described with reference to FIGS. 11 to 36B. In FIGS. 11A to 36B, the same reference numerals are used to denote the same elements as in FIGS. 2 to 6B, and thus, repeated descriptions thereof may be omitted.

Referring to FIG. 11, a plurality of sacrificial layers 104 and a plurality of active layers 106 may be alternately stacked on an upper surface 102M of a substrate 102 in a vertical direction (Z direction). In one or more embodiments, the plurality of sacrificial layers 104 and the plurality of active layers 106 may each include a semiconductor material. In one or more embodiments, each of the plurality of sacrificial layers 104 may include an undoped SiGe layer or a SiGe layer doped with carbon (C) atoms, and each of the plurality of active layers 106 may include a Si layer. In the vertical direction (Z direction), a thickness T1 of each of the plurality of active layers 106 may be less than a thickness T2 of each of the plurality of sacrificial layers 104. In one or more embodiments, the thickness T2 of each of the plurality of sacrificial layers 104 may be at least three times greater than the thickness T1 of each of the plurality of active layers 106, without being limited thereto.

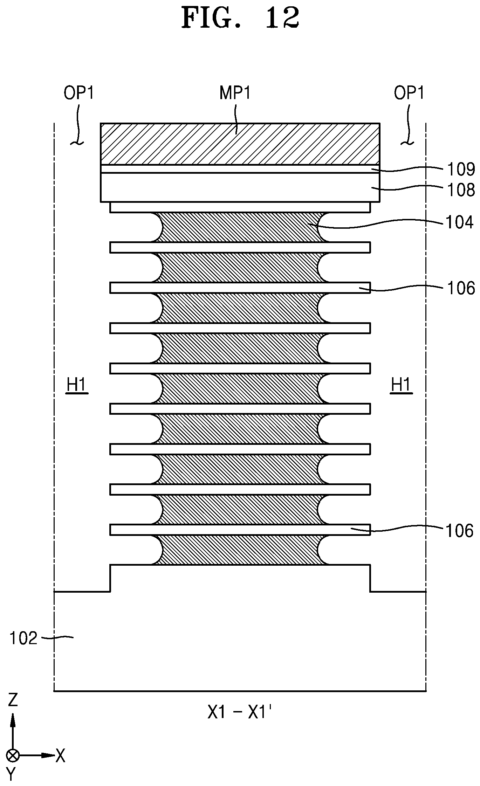

Referring to FIG. 12, a silicon oxide film 108 and a silicon nitride film 109 may be sequentially formed on a stack structure including the plurality of sacrificial layers 104 and the plurality of active layers 106, and a mask pattern MP1 may be formed on the silicon nitride film 109. The mask pattern MP1 may include a plurality of first openings OP1. In one or more embodiments, the mask pattern MP1 may include a photoresist pattern, without being limited thereto. Thereafter, the silicon nitride film 109 and the silicon oxide film 108 may be sequentially etched through the plurality of first openings OP1 by using the mask pattern MP1 as an etch mask. Subsequently, the stack structure including the plurality of sacrificial layers 104 and the plurality of active layers 106 may be etched, and thus, a plurality of holes H1 exposing the substrate 102 may be formed in the stack structure.

Afterwards, portions of the plurality of sacrificial layers 104 may be removed through the plurality of first openings OP1 and the plurality of holes H1. As a result, the plurality of active layers 106 may protrude in a first lateral direction (X direction) between the remaining portions of the plurality of sacrificial layers 104.

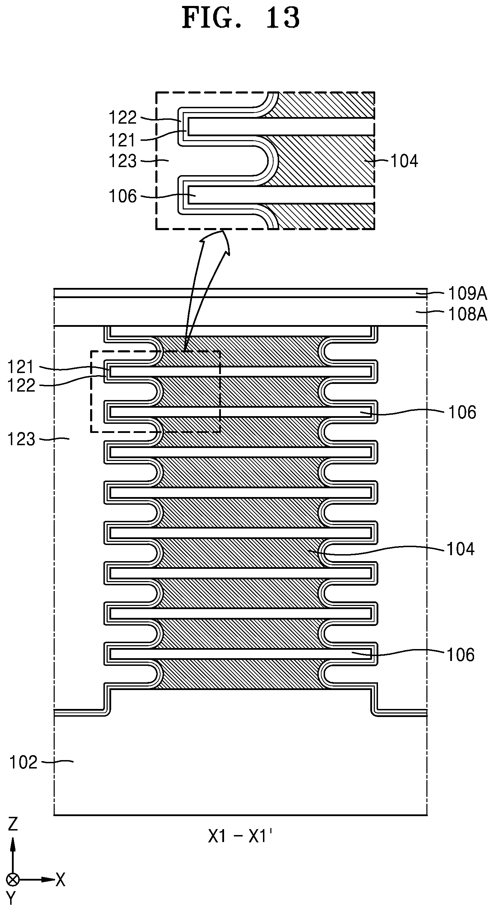

Referring to FIG. 13, in the resultant structure of FIG. 12, a first insulating liner 121 and a second insulating liner 122 may be formed to conformally cover surfaces exposed through the plurality of holes H1. A buried insulating film 123 may be formed to fill the remaining spaces of the plurality of holes H1, which are defined by the second insulating liner 122. In one or more embodiments, the first insulating liner 121 may include silicon oxide, the second insulating liner 122 may include silicon nitride, and the buried insulating film 123 may include silicon oxide.

Next, the mask pattern MP1, the silicon nitride film 109, and the silicon oxide film 108 may be removed by using a chemical mechanical polishing (CMP) process. Thus, a planar top surface at which a plurality of active layers 106 located at a farthest vertical level from the substrate 102, from among the plurality of active layers 106, are exposed may be formed. Thereafter, a silicon oxide film 108A and a silicon nitride film 109A may be formed on the obtained resultant structure.

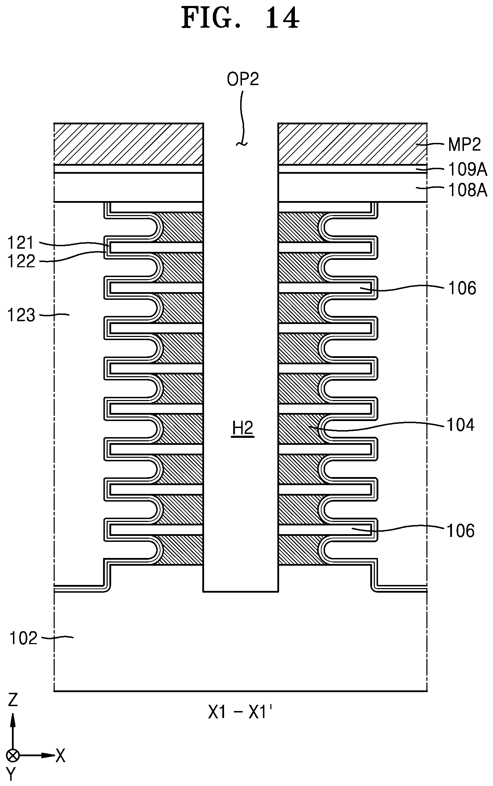

Referring to FIG. 14, a mask pattern MP2 may be formed on the silicon nitride film 109A. The mask pattern MP2 may include a second opening OP2. The second opening OP2 may be located at a position shifted in the first lateral direction (X direction) from positions of the plurality of first openings OP1 formed in the mask pattern MP1 shown in FIG. 12. In one or more embodiments, the mask pattern MP2 may include a photoresist pattern, without being limited thereto. The second opening OP2 may be positioned above a middle portion of the stack structure including the plurality of sacrificial layers 104 and the plurality of active layers 106.

The stack structure including the plurality of sacrificial layers 104 and the plurality of active layers 106 may be etched through the second opening OP2 by using the mask pattern MP2 as an etch mask, and thus, a hole H2 exposing the substrate 102 may be formed in the stack structure.

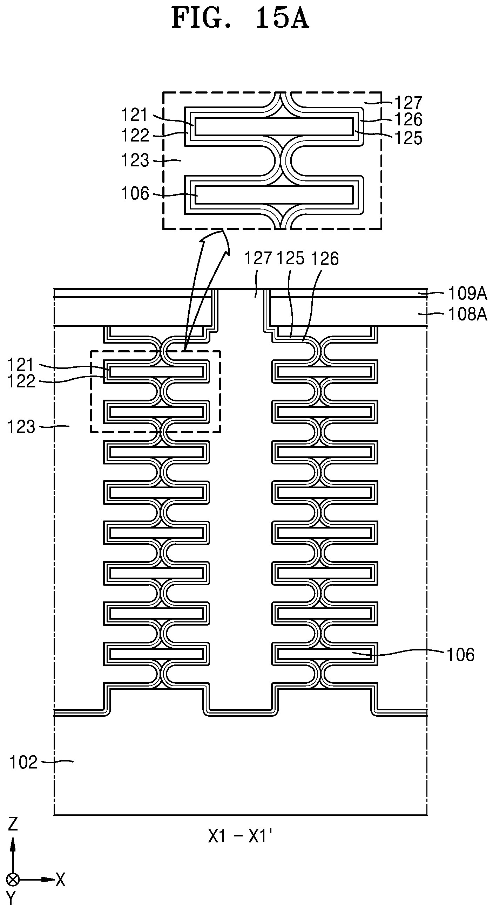

Referring to FIGS. 15A and 15B, in the resultant structure of FIG. 14, the plurality of sacrificial layers 104, which are exposed through the hole H2, may be removed. During the removal of the plurality of sacrificial layers 104, respective portions of the plurality of active layers 106 may be consumed. Thereafter, a third insulating liner 125 and a fourth insulating liner 126 may be formed to conformally cover surfaces of the plurality of active layers 106, which are exposed through the hole H2. A buried insulating film 127 may be formed to fill the remaining spaces of the hole H2, which are defined by the fourth insulating liner 126. In one or more embodiments, the third insulating liner 125 may include silicon oxide, the fourth insulating liner 126 may include silicon nitride, and the buried insulating film 127 may include silicon oxide. Afterwards, the mask pattern MP2 may be removed using a CMP process to expose a top surface of the silicon nitride film 109A.

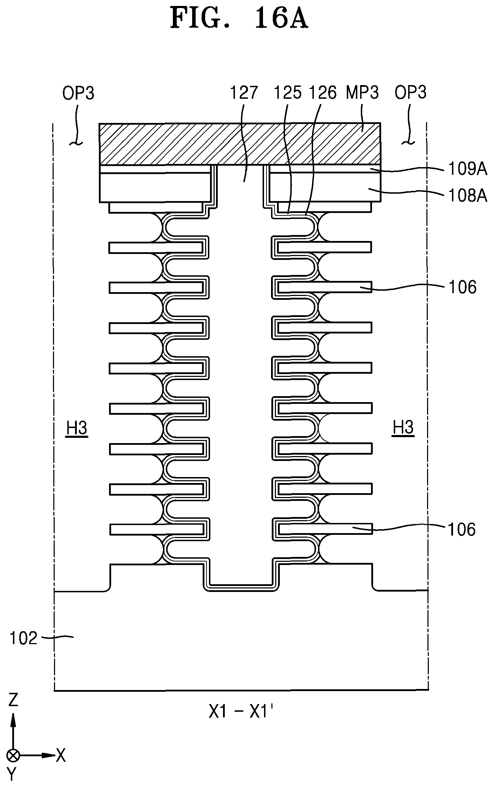

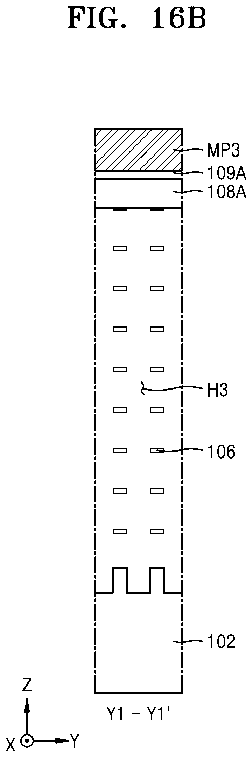

Referring to FIGS. 16A and 16B, a mask pattern MP3 may be formed on the resultant structure on which the processes described with reference to FIGS. 15A and 15B have been performed. The mask pattern MP3 may include a plurality of third openings OP3. The mask pattern MP3 may include a photoresist pattern, without being limited thereto.

Thereafter, the silicon nitride film 109A and the silicon oxide film 108A may be sequentially etched through the plurality of third openings OP3 by using the mask pattern MP3 as an etch mask. Subsequently, the buried insulating film 123, the second insulating liner 122, and the first insulating liner 121 may be sequentially removed to form a plurality of holes H3 exposing the plurality of active layers 106 and the substrate 102.

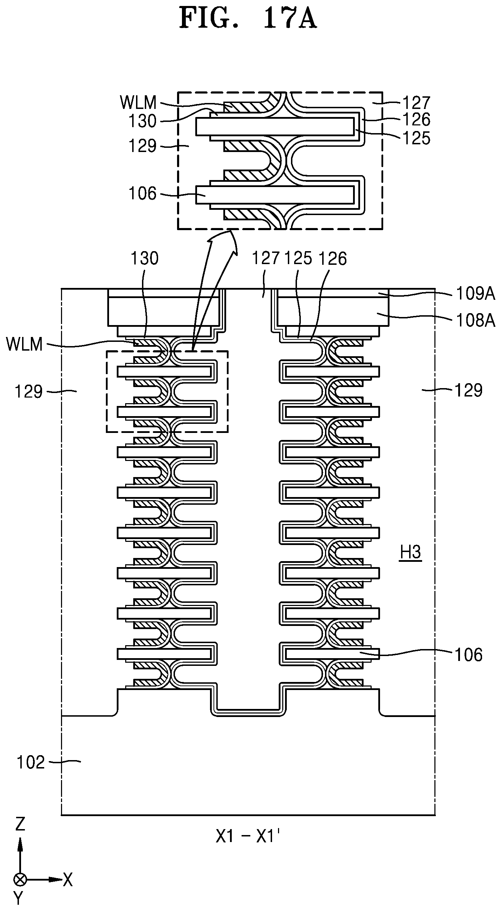

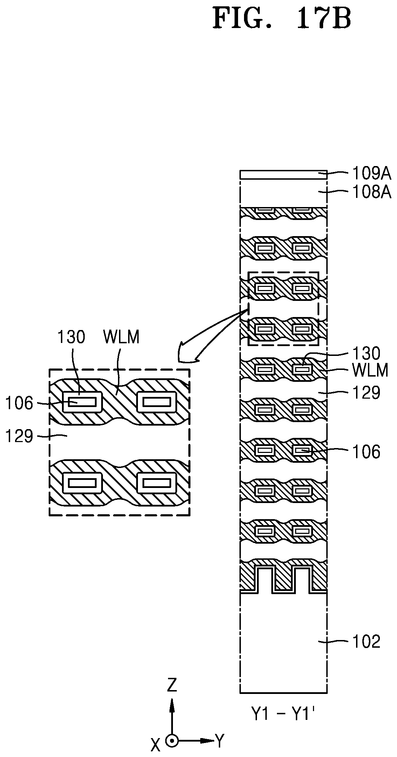

Referring to FIGS. 17A and 17B, the mask pattern MP3 may be removed from the resultant structure of FIGS. 16A and 16B to expose the top surface of the silicon nitride film 109A. Next, a gate dielectric film 130 may be formed to conformally cover surfaces exposed by the plurality of holes H3, a conductive layer may be formed to cover a surface of the gate dielectric film 130, and a protective pattern may be formed to cover portions desired to be left, of the conductive layer. Thereafter, exposed portions of the conductive layer may be selectively removed by using the protective pattern as an etch mask, and thus, a plurality of conductive patterns WLM for forming a plurality of word lines may be formed. Subsequently, the remaining spaces of the plurality of holes H3 by which the plurality of conductive patterns WLM are exposed may be filled by an insulating structure 129. The insulating structure 129 may include a silicon oxide film, a silicon nitride film, or a combination thereof. In one or more embodiments, the insulating structure 129 may include a silicon oxide liner, a silicon nitride liner, and a silicon oxide film for filling, which are sequentially stacked on surfaces of the gate dielectric film 130 and the plurality of conductive patterns WLM. After the insulating structure 129 is formed, the top surface of the silicon nitride film 109A may be exposed around the insulating structure 129.

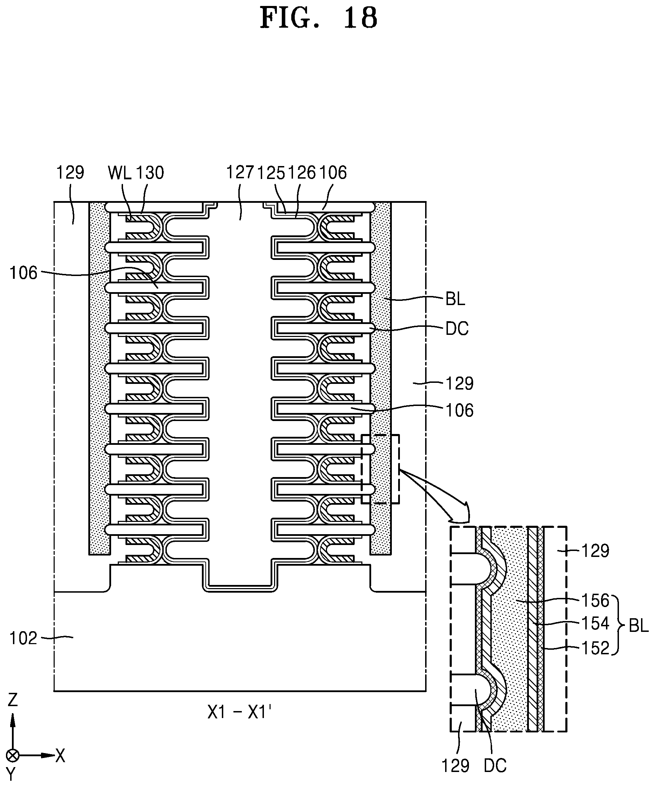

Referring to FIG. 18, in the resultant structure on which the processes described with reference to FIGS. 17A and 17B have been performed, a plurality of bit lines BL may be formed to pass through a portion of the insulating structure 129 in the vertical direction (Z direction). Each of the plurality of bit lines BL may be formed to contact a plurality of active layers 106, which are arranged in a line in the vertical direction (Z direction). To form the plurality of bit lines BL, a plurality of vertical holes may be formed to pass through a portion of the insulating structure 129 in the vertical direction (Z direction). The plurality of active layers 106, which are arranged in a line in the vertical direction (Z direction), may be exposed through the plurality of vertical holes. A dopant may be doped into each of the plurality of active layers 106 exposed through the plurality of vertical holes to form direct contacts DC. Thereafter, a metal silicide film 152, a conductive liner 154, and a conductive plug 156 may be sequentially formed inside the plurality of vertical holes. The dopant may include p-type or n-type impurity ions. For example, the dopant may include boron (B), phosphorus (P), or arsenic (As), without being limited thereto. Afterwards, the silicon nitride film 109A and the silicon oxide film 108A may be removed by using a chemical mechanical polishing (CMP) process. Subsequently, a planar top surface at which a plurality of active layers 106 located at a farthest vertical level from the substrate 102, from among the plurality of active layers 106, are exposed may be formed.

Referring to FIGS. 19A and 19B, a mask pattern 160 may be formed to cover the resultant structure on which the processes described with reference to FIG. 18 have been performed. The mask pattern 160 may include a fourth opening OP4. In a view from above, a position of the fourth opening OP4 may be the same as or similar to the position of the second opening OP2 shown in FIG. 14. The mask pattern 160 may include a silicon nitride film.

The buried insulating film 127, the fourth insulating liner 126, and the third insulating liner (refer to 125 in FIG. 18) may be removed through the fourth opening OP4. Thus, a hole H4 exposing the plurality of active layers 106, a plurality of gate dielectric films 130, and the substrate 102 may be formed. Thereafter, exposed portions of the plurality of gate dielectric films 130 may be partially removed through the hole H4 to expose the plurality of conductive patterns WLM. Respective portions of the plurality of conductive patterns WLM, which are exposed, may be etched, and thus, a plurality of word lines WL may be formed from the plurality of conductive patterns WLM. As a result, as shown in the enlarged view of FIG. 19B, the insulating structure 129 may be exposed around the word line WL surrounding the active layer 106 inside the hole H4.

Referring to FIG. 20, an insulating liner 172 may be formed to conformally cover a surface of each of the plurality of word lines WL, the plurality of gate dielectric films 130, and the insulating structure 129, which are exposed inside the hole H4. Thereafter, a buried insulating film 173 may be formed on the insulating liner 172 to partially fill respective spaces between the plurality of active layers 106. The buried insulating film 173 may be formed to surround a portion of each of the plurality of active layers 106 with the insulating liner 172 therebetween. After the buried insulating film 173 is formed, portions of the plurality of active layers 106 and the insulating liner 172 covering the plurality of active layers 106 may protrude in the first lateral direction (X direction) over a sidewall of the buried insulating film 173 inside the hole H4.

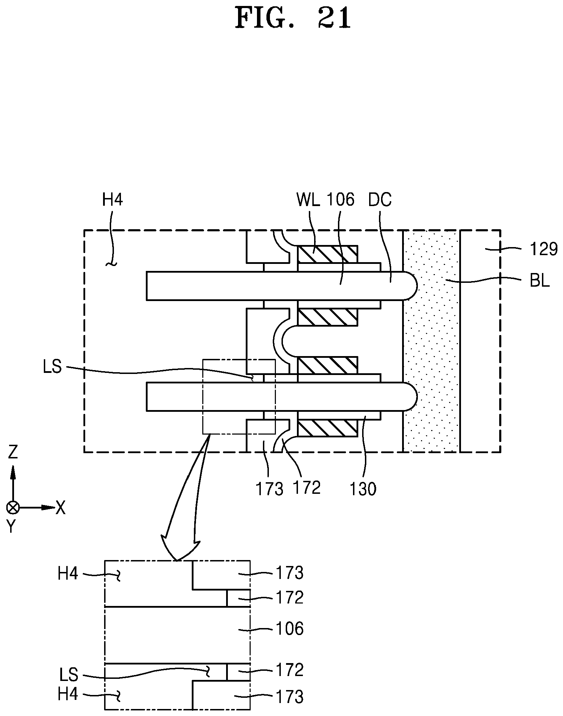

Referring to FIG. 21, in the resultant structure of FIG. 20, a portion of the insulating liner 172 exposed inside the hole H4 may be removed to expose a portion of each of the plurality of active layers 106, and a plurality of loop spaces LS respectively surrounding the plurality of active layers 106 may be respectively formed between the plurality of active layers 106 and the buried insulating film 173. The plurality of loop spaces LS may be connected to the hole H4. To form the plurality of loop spaces LS connected to the hole H4, a portion of the insulating liner 172 may be etched by using a wet etching process or an isotropic dry etching process through the hole H4.

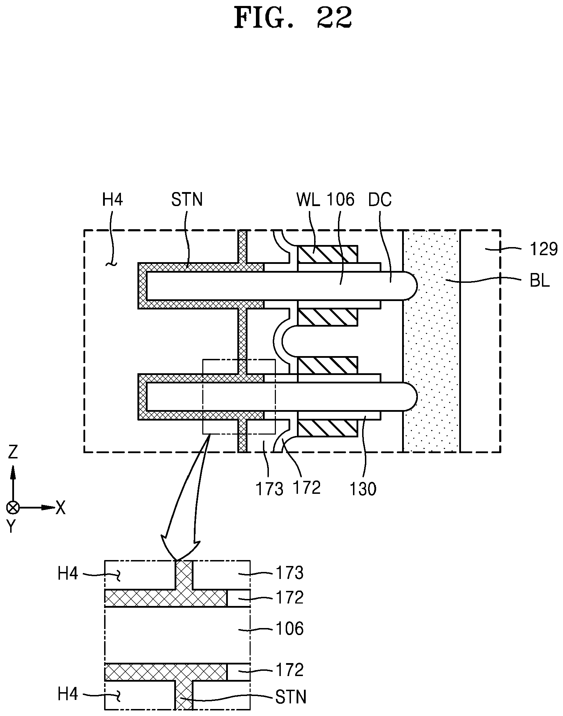

Referring to FIG. 22, in the resultant structure of FIG. 21, a metal-containing amorphous film STN may be formed to fill the plurality of loop spaces LS. The metal-containing amorphous film STN may fill the plurality of loop spaces LS and conformally cover surfaces of the plurality of active layers 106 and a surface of the buried insulating film 173, which are exposed by the hole H4. In one or more embodiments, the metal-containing amorphous film STN may include an amorphous hafnium oxide film, an amorphous zirconium oxide film, an amorphous tantalum oxide film, an amorphous niobium oxide film, an amorphous titanium oxide film, an amorphous lanthanum oxide film, or a combination thereof, without being limited thereto.

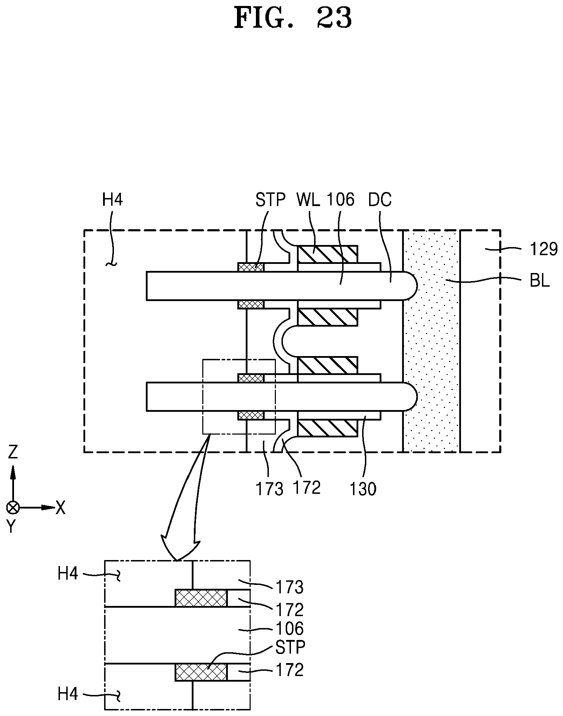

Referring to FIG. 23, in the resultant structure of FIG. 22, a portion of the metal-containing amorphous film STN may be etched by using an atomic layer etching process to form a plurality of metal-containing insulating loop patterns STP. The plurality of metal-containing insulating loop patterns STP may include portions of the metal-containing amorphous film STN, which fill the plurality of loop spaces LS. During the formation of the plurality of metal-containing insulating loop patterns STP, an exposed portion of the buried insulating film 173 may be consumed due to an etching atmosphere of the metal-containing amorphous film STN, and thus, a portion of the buried insulating film 173 may be removed. As a result, inside the hole H4, the plurality of metal-containing insulating loop patterns STP may protrude in the first lateral direction (X direction) toward the center of the hole H4 further than the exposed surface of the buried insulating film 173.

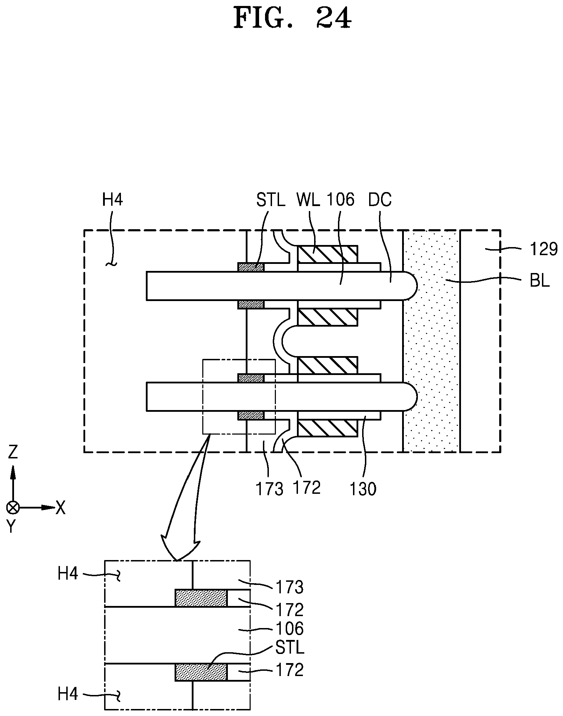

Referring to FIG. 24, in the resultant structure of FIG. 23, the plurality of metal-containing insulating loop patterns STP may be crystallized, and thus, a plurality of metal-containing insulating loops STL including a crystallized metal oxide may be formed.

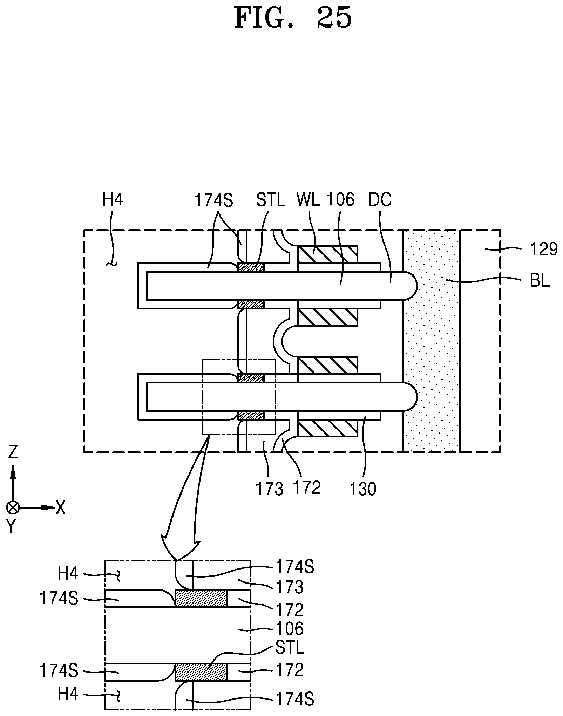

Referring to FIG. 25, by performing a selective oxide film deposition process on the resultant structure of FIG. 24, an oxide liner 174S may be selectively formed only on the exposed surfaces of the plurality of active layers 106 and the exposed surface of the buried insulating film 173, from among surfaces exposed by the hole H4, without being deposited on exposed surfaces of the plurality of metal-containing insulating loops STL including the crystallized metal oxide. Because the selective oxide film deposition process is performed under a condition that the oxide liner 174S is not formed on a surface of each of the plurality of metal-containing insulating loops STL, the oxide liner 174S may be formed at positions adjacent to the plurality of metal-containing insulating loops STL to have holes exposing the plurality of metal-containing insulating loops STL. The oxide liner 174S may be formed such that at least a portion of a surface facing the metal-containing insulating loop STL, from among surfaces of the oxide liner 174S, is spaced apart from the metal-containing insulating loop STL.

In one or more embodiments, the oxide liner 174S may include a silicon oxide film. In this case, the selective oxide film deposition process of forming the oxide liner 174S may include performing an atomic layer deposition process of sequentially supplying a deposition inhibitor, a silicon precursor, and a co-reactant at least once. For instance, in the selective oxide film deposition process of forming the oxide liner 174S, the atomic layer deposition process of sequentially supplying the deposition inhibitor, the silicon precursor, and the co-reactant may be repeated a desired number of times. As an example, the desired number of times may be selected from a range of 1 to 20 times.

The deposition inhibitor may include a material that is selectively self-assembled or adsorbed on portions on which the oxide liner 174S is not desired to be formed, that is, on surfaces of each of the plurality of metal-containing insulating loops STL. The deposition inhibitor may be self-assembled or adsorbed on the surfaces of each of the plurality of metal-containing insulating loops STL and block the adsorption of the silicon precursor supplied in a subsequent operation.

In one or more embodiments, the deposition inhibitor may include self-assembled monolayer (SAM) forming materials, such as octadecyltrichlorosilane (ODTS) and octadecylphosphonic acid (ODPA), or a material from among small molecular inhibitors (SMI), such as dimethylamino-trimethylsilane (DMATMS) and acetylacetone.

The silicon precursor may include bis(diethylamino)silane (BDEAS), without being limited thereto.

The co-reactant may include O₂, O₃, H₂O, O₂ plasma, or a combination thereof, without being limited thereto.

In one or more embodiments, to increase a selective deposition selectivity in the selective oxide film deposition process, the atomic layer deposition process and the atomic layer etching process, which are described above, may be alternately repeated a plurality of times.

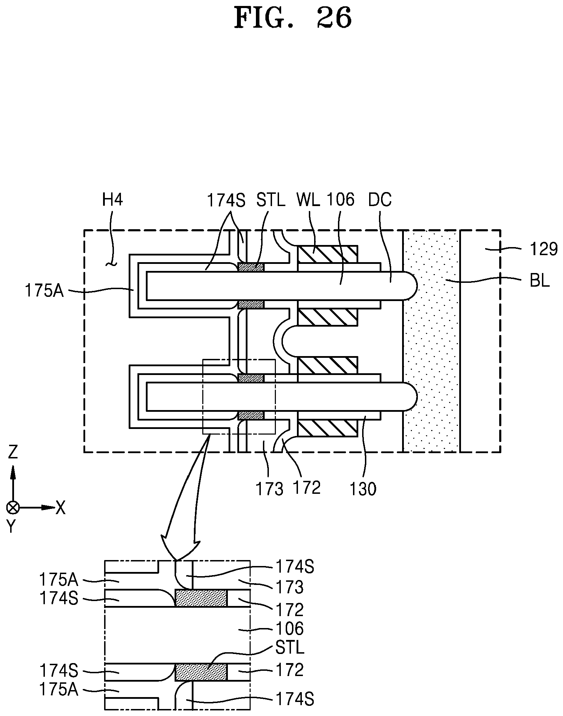

Referring to FIG. 26, in the resultant structure on which the processes described with reference to FIG. 25 have been performed, a first silicon nitride liner 175A may be formed to conformally cover the oxide liner 174S. The first silicon nitride liner 175A may be formed to cover the oxide liner 174S and the plurality of metal-containing insulating loops STL.

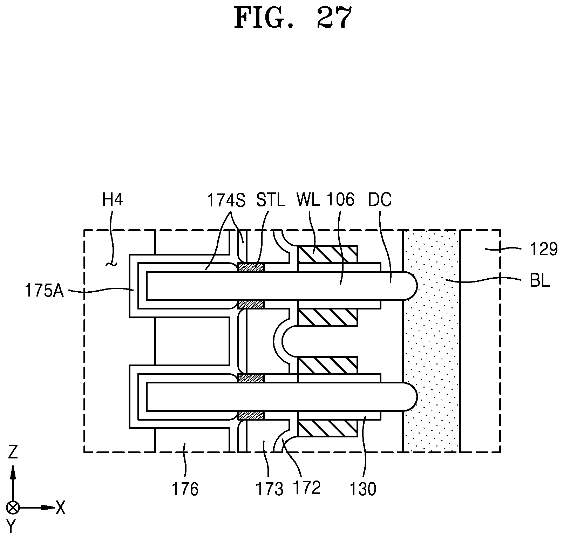

Referring to FIG. 27, in the resultant structure of FIG. 26, a silicon oxide film may be formed to fill the hole H4 and then partially removed to form a silicon oxide pattern 176 exposing a portion of the silicon nitride liner 175A.

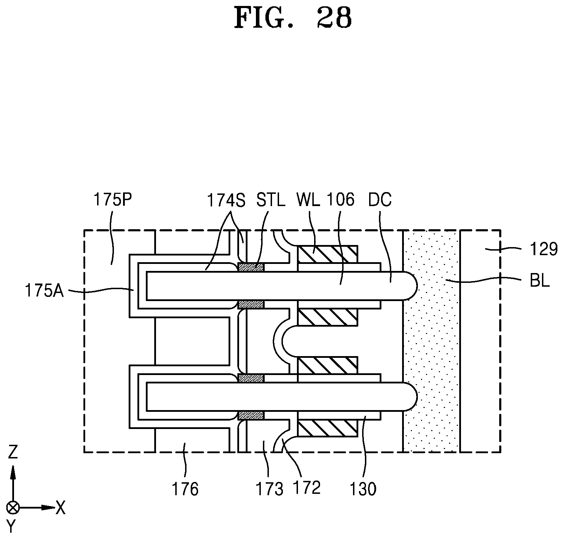

Referring to FIG. 28, in the resultant structure of FIG. 27, a silicon nitride plug 175P may be formed to fill the hole H4.

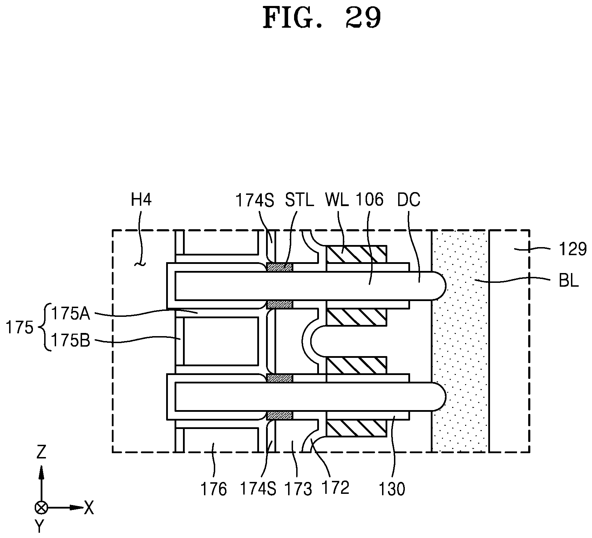

Referring to FIG. 29, a portion of the silicon nitride plug 175P may be removed from the resultant structure of FIG. 28. Thus, a second silicon nitride liner 175B, which includes the remaining portion of the silicon nitride plug 175P, may be formed. A partial region of the first silicon nitride liner 175A may be exposed inside the hole H4 through the second silicon nitride liner 175B. The exposed first silicon nitride liner 175A may be removed. Thereafter, partial regions of the oxide liner 174S may be exposed through the second silicon nitride liner 175B inside the hole H4. The first silicon nitride liner 175A and the second silicon nitride liner 175B may constitute a silicon nitride liner structure 175 that surrounds the silicon oxide pattern 176.

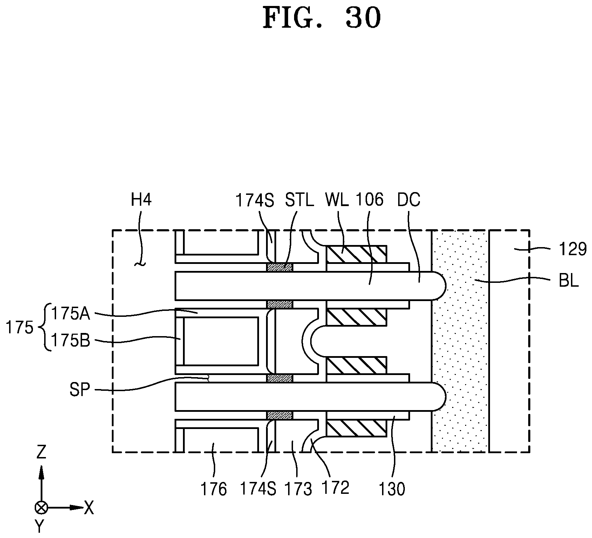

Referring to FIG. 30, in the resultant structure of FIG. 29, the oxide liner 174S may be removed through the hole H4, and thus, spaces SP may be formed around the plurality of active layers 106. The oxide liner 174S may be removed by using a wet etching process or an isotropic dry etching process. During the removal of the oxide liner 174S, the plurality of metal-containing insulating loops STL may serve as an etch stop film. Accordingly, by removing the oxide liner 174S the spaces SP formed around the plurality of active layers 106 may be constantly controlled to have a desired length in the first lateral direction (X direction). The portions of the oxide liner 174S that extend in the first lateral direction (X direction) may be removed, but the portions of the oxide liner 174S that extend in the vertical direction (Z direction) may remain. That is, the portions of the oxide liner 174S between the silicon oxide pattern 176 and the buried insulating film 173 may remain.

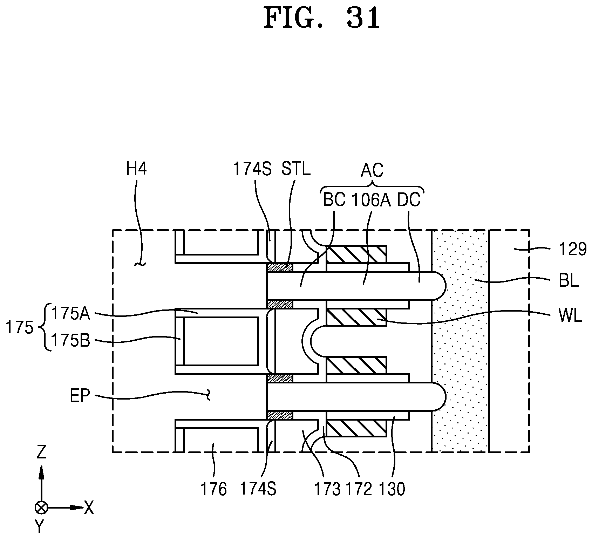

Referring to FIG. 31, in the resultant structure on which the processes described with reference to FIG. 30 have been performed, respective portions of the plurality of active layers 106, which are exposed through the hole H4, may be removed to form a plurality of active regions AC. A plurality of electrode spaces EP, of which a size in the vertical direction (Z direction) is defined by the first silicon nitride liner structure 175, may be formed at positions adjacent to the plurality of active regions AC. Afterwards, a buried contact BC may be formed in each of the plurality of active layers 106 by doping a dopant into the plurality of active layers 106 through the hole H4 and the plurality of electrode spaces EP, and thus, the plurality of active regions AC may be formed. In one or more embodiments, the dopant may include p-type or n-type impurity ions. For example, the dopant may include boron (B), phosphorus (P), or arsenic (As), without being limited thereto.

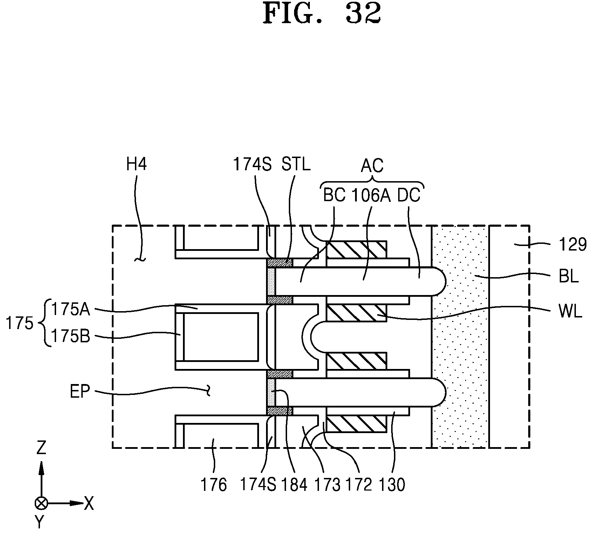

Referring to FIG. 32, a metal silicide film 184 may be formed on a surface of each of the plurality of active regions AC exposed in the plurality of electrode spaces EP. In one or more embodiments, the formation of the metal silicide film 184 may include forming a metal-silicon composite layer by vapor-depositing a metal and silicon on the surface of each of the plurality of active regions AC and silicidating the metal-silicon composite layer by using a thermal annealing process or an annealing process.

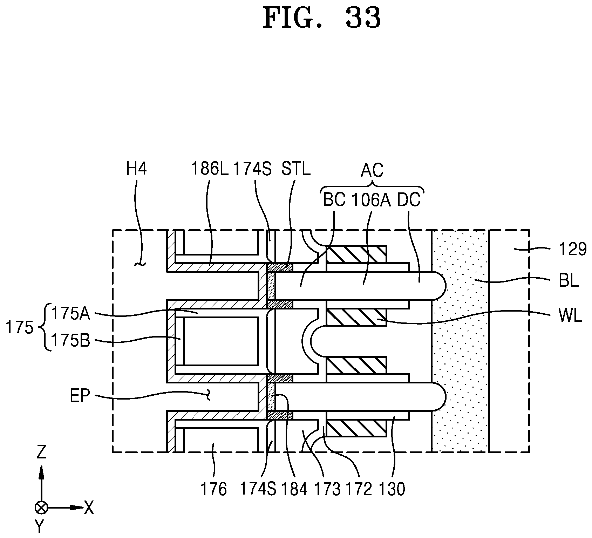

Referring to FIG. 33, a conductive layer 186L may be formed to conformally cover surfaces exposed by the hole H4 and the plurality of electrode spaces EP. A constituent material of the conductive layer 186L may be the same as a constituent material of the first electrode 186, which has been described above.

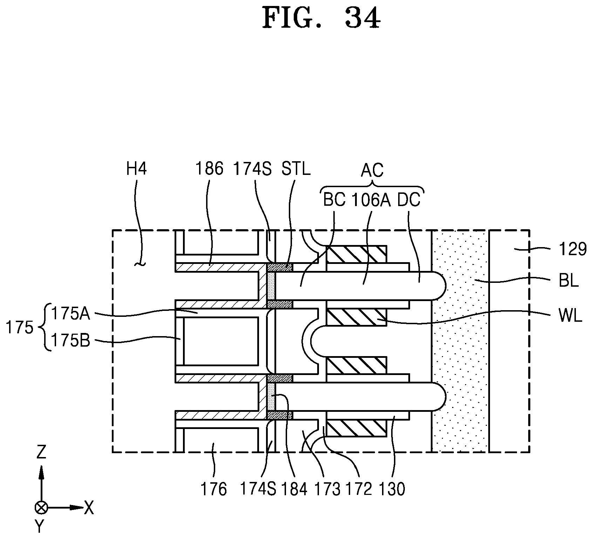

Referring to FIG. 34, portions of the conductive layer 186L, which are outside the plurality of electrode spaces EP, may be removed to form a plurality of first electrodes 186.

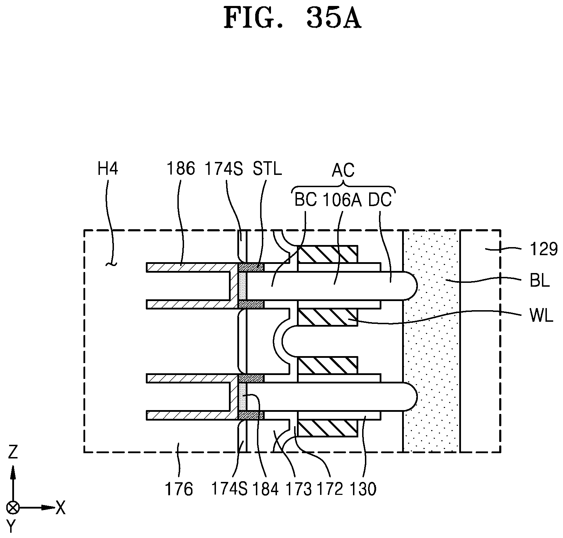

Referring to FIGS. 35A and 35B, the silicon nitride liner structure 175 and the silicon oxide pattern 176 may be removed from the resultant structure on which the processes described with reference to FIG. 34 have been performed. Thus, an outer surface of each of the plurality of first electrodes 186 may be exposed.

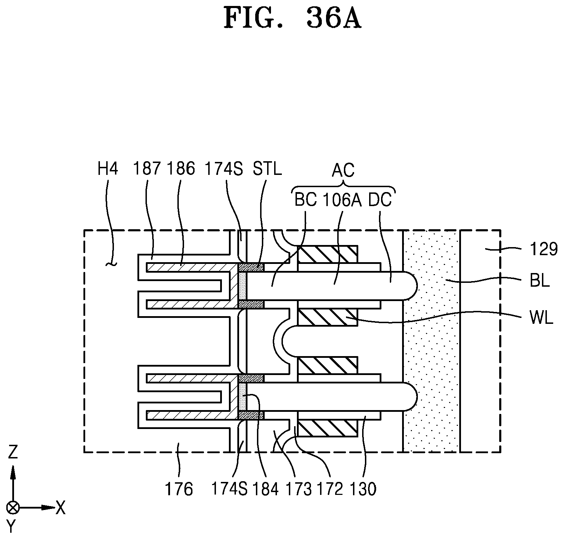

Referring to FIGS. 36A and 36B, in the resultant structure of FIGS. 35A and 35B, a dielectric film 187 may be formed to conformally cover respective exposed surfaces of the plurality of first electrodes 186 and an exposed surface of the oxide liner 174S.

Thereafter, as shown in FIGS. 2 to 4, a second electrode 188 covering the dielectric film 187 and a plate electrode 190 may be sequentially formed, and thus, the semiconductor memory device 100 shown in FIGS. 2 to 6B may be manufactured.

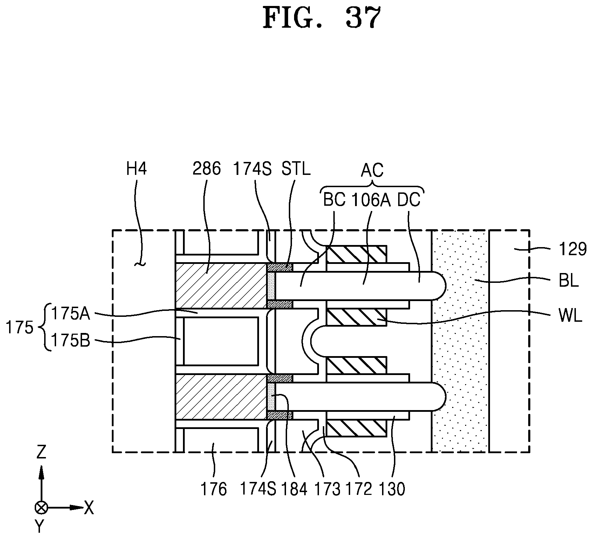

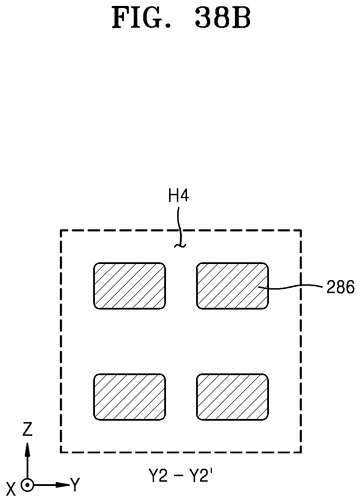

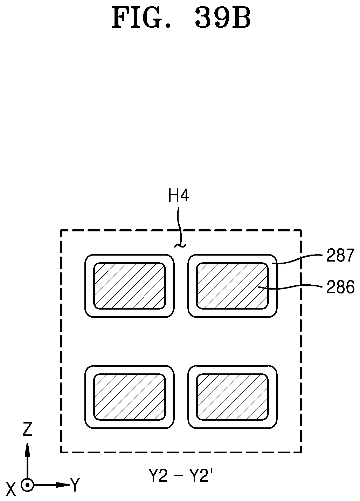

FIGS. 37 to 39B are diagrams of a method of manufacturing a semiconductor memory device, according to one or more embodiments. More specifically, FIGS. 37, 38A, and 39A are each an enlarged cross-sectional view of an example of a region corresponding to the partial region "EX2" of FIG. 7, according to a process sequence. FIGS. 38B and 39B are each a cross-sectional view of an example of a partial region corresponding to a cross-section taken along line Y2 - Y2' of FIG. 4, according to the process sequence. An example of a method of manufacturing the semiconductor memory device 200, which has been described with reference to FIGS. 7 to 9, is described with reference to FIGS. 37 to 39B. In FIGS. 37 to 39B, the same reference numerals are used to denote the same elements as in FIGS. 2 to 9, and thus, repeated descriptions thereof may be omitted.

Referring to FIG. 37, the processes described with reference to FIGS. 11 to 32 may be performed. Thereafter, in the resultant structure of FIG. 32, a first electrode 286 may be formed to fill the plurality of electrode spaces EP.

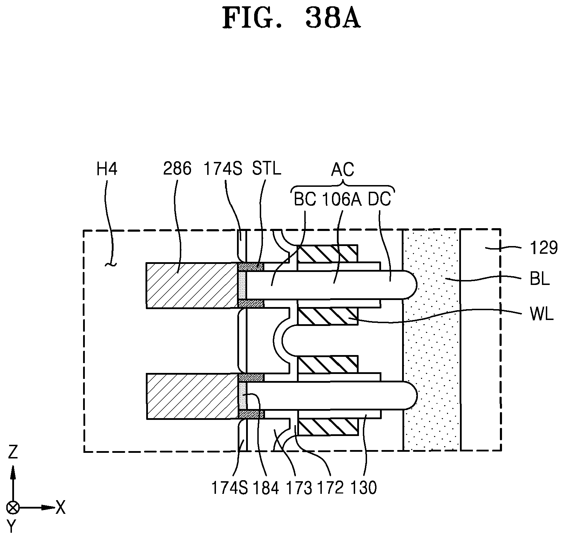

Referring to FIGS. 38A and 38B, a silicon nitride liner structure 175 and the silicon oxide pattern 176 may be removed from the resultant structure on which the processes described with reference to FIG. 37 have been performed. Thus, an outer surface of each of a plurality of first electrodes 286 may be exposed.

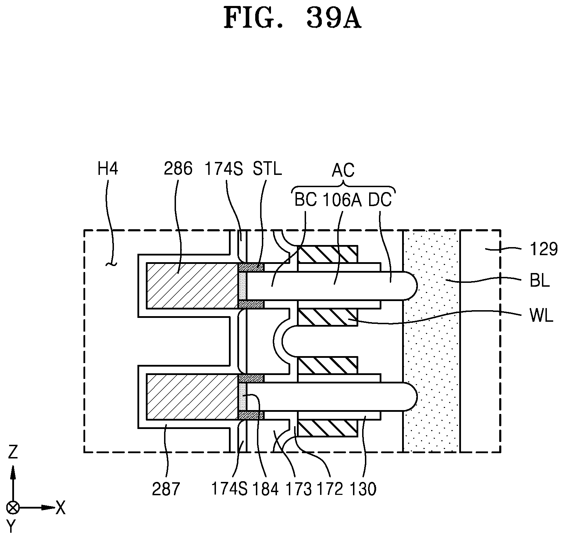

Referring to FIGS. 39A and 39B, in the resultant structure of FIGS. 38A and 38B, a dielectric film 287 may be formed to conformally cover an exposed surface of each of the plurality of first electrodes 286 and an exposed surface of an oxide liner 174S.

Afterwards, as shown in FIGS. 7 and 8, a second electrode 288 covering the dielectric film 287 and a plate electrode 190 may be sequentially formed, and thus, the semiconductor memory device 200 shown in FIGS. 7 to 9 may be manufactured.

To manufacture the semiconductor memory device 300 shown in FIG. 10, processes similar to those described with reference to FIGS. 11 to 36B may be performed. However, by controlling a selective deposition selectivity in the selective oxide film deposition process for forming the oxide liner 174S, which has been described with reference to FIG. 25, an oxide liner 374S may be formed instead of the oxide liner 174S. The formation of the oxide liner 374S may include bringing a surface of the oxide liner 374S, which faces the metal-containing insulating loop STL, into contact with an outer surface of the metal-containing insulating loop STL such that no empty space remains between the oxide liner 374S and the metal-containing insulating loop STL.

Subsequently, the processes described with reference to FIGS. 26 to 36B may be performed on the obtained resultant structure, and thus, the semiconductor memory device 300 shown in FIG. 10 may be manufactured.

Although the methods of manufacturing the semiconductor memory devices 100, 200, and 300 shown in FIGS. 2 to 10 have been described with reference to FIGS. 11 to 39B, it will be understood that the semiconductor memory devices 100, 200, and 300 shown in FIGS. 2 to 10 and semiconductor memory devices having variously changed structures may be manufactured by applying various modifications and changes to the processes described with reference to FIGS. 11 to 39B within the scope of the disclosure.

In one or more embodiments, a semiconductor memory device is provided that has a structure that may be capable of maximizing the capacitance of a capacitor in a limited area by preventing the leaning or collapse of the capacitor, even when an area occupied by a plurality of memory cells arranged three-dimensionally is reduced due to the miniaturization and high integration of the plurality of memory cells.

Embodiments are set out in the following Clauses:
Clause 1. A semiconductor memory device comprising:
   a substrate having an upper surface;
   an active region spaced apart from the substrate in a vertical direction that is perpendicular to the upper surface of the substrate, and extending in a first lateral direction that is parallel to the upper surface of the substrate;
   a word line at least partially surrounding the active region and extending in a second lateral direction that is parallel to the upper surface of the substrate and perpendicular to the first lateral direction;
   a capacitor comprising a first electrode connected to the active region; and
   an insulating loop protruding from the first electrode of the capacitor toward the word line in the first lateral direction, the insulating loop surrounding a portion of the active region and comprising a metal element.
Clause 2. The semiconductor memory device of Clause 1, wherein the metal element comprises a crystallized metal oxide.
Clause 3. The semiconductor memory device of Clause 1 or Clause 2, wherein the capacitor further comprises a dielectric film covering a surface of the first electrode, and
   wherein the dielectric film contacts the insulating loop.
Clause 4. The semiconductor memory device of any preceding Clause, wherein the capacitor further comprises a dielectric film covering a surface of the first electrode, and
   wherein the dielectric film comprises a metal element of a same type as the metal element of the insulating loop.
Clause 5. The semiconductor memory device of any preceding Clause, wherein the capacitor further comprises a dielectric film covering a surface of the first electrode and a second electrode spaced apart from the first electrode with the dielectric film therebetween,
   wherein the active region comprises a channel region at least partially surrounded by the word line and a buried contact between the first electrode of the capacitor and the channel region,
   wherein the semiconductor memory device further comprises:
      an insulating liner at least partially surrounding the buried contact, the insulating liner contacting a surface among surfaces of the insulating loop that is closest to the word line in the first lateral direction;
      a buried insulating film at least partially surrounding the insulating liner and the insulating loop; and
      an oxide liner covering a surface of the buried insulating film facing the dielectric film and the second electrode,
   wherein the oxide liner at least partially surrounds the insulating loop, and
   wherein the dielectric film comprises a protrusion protruding toward the word line in the first lateral direction, the protrusion being between the oxide liner and the insulating loop.
Clause 6. The semiconductor memory device of any preceding Clause, further comprising a metal silicide film between the first electrode of the capacitor and the active region, the metal silicide film contacting each of the first electrode and the active region,
   wherein the metal silicide film is surrounded by the insulating loop.
Clause 7. The semiconductor memory device of any preceding Clause, wherein the capacitor further comprises a dielectric film covering a surface of the first electrode and a second electrode spaced apart from the first electrode with the dielectric film therebetween,
   wherein the first electrode of the capacitor has a cylindrical shape defining an inner space configured to accommodate a portion of the dielectric film and a portion of the second electrode, and
   wherein the dielectric film covers an inner surface and an outer surface of the first electrode.
Clause 8. The semiconductor memory device of any of Clauses 1-6, wherein the capacitor further comprises a dielectric film covering a surface of the first electrode and a second electrode spaced apart from the first electrode with the dielectric film therebetween,
   wherein the first electrode of the capacitor has a pillar shape with a filled interior, and
   wherein the dielectric film covers an outer surface of the first electrode.
Clause 9. The semiconductor memory device of any preceding Clause, further comprising a bit line extending in the vertical direction on the substrate from the upper surface of the substrate, the bit line being connected to the active region,
   wherein the bit line is spaced apart from the capacitor in the first lateral direction with the word line therebetween.
Clause 10. The semiconductor memory device of any preceding Clause, further comprising a gate dielectric film between the word line and the active region,
   wherein the gate dielectric film is aligned and collinear with the insulating loop in the first lateral direction.
Clause 11. A semiconductor memory device having a three-dimensional (3D) structure, the semiconductor memory device comprising:
   a substrate having an upper surface; and
   a memory cell block on the substrate, the memory cell block comprising:
      a plurality of active regions arranged in a line in a vertical direction that is perpendicular to the upper surface of the substrate;
      a plurality of word lines, each word line of the plurality of word lines at least partially surrounding a respective active region of the plurality of active regions and extending in a second lateral direction that is parallel to the upper surface of the substrate;
      a bit line extending in the vertical direction on the substrate, the bit line being connected to a first side of each active region of the plurality of active regions;
      a plurality of capacitors, each capacitor of the plurality of capacitors comprising a first electrode connected to a second side of a respective active region of the plurality of active regions, the second side being opposite to the first side; and
      a plurality of insulating loops arranged in a line in the vertical direction, each insulating loop of the plurality of insulating loops protruding from the first electrode of a respective capacitor of the plurality of capacitors toward a corresponding word line of the plurality of word lines in a first lateral direction that is parallel to the upper surface of the substrate and perpendicular to the second lateral direction, each insulating loop of the plurality of insulating loops surrounding a portion of a respective active region of the plurality of active regions,
   wherein each insulating loop of the plurality of insulating loops comprises a metal element.
Clause 12. The semiconductor memory device of Clause 11, wherein the plurality of insulating loops comprise a crystallized metal oxide.
Clause 13. The semiconductor memory device of Clause 11 or Clause 12, wherein each capacitor of the plurality of capacitors further comprises a dielectric film covering a surface of the first electrode and contacting at least one insulating loop of the plurality of insulating loops.
Clause 14. The semiconductor memory device of any of Clauses 11-13, wherein each capacitor of the plurality of capacitors further comprises a dielectric film covering a surface of the first electrode, and
   wherein each of the dielectric film and the plurality of insulating loops comprises a metal oxide.
Clause 15. The semiconductor memory device of any of Clauses 11-14, further comprising a plurality of metal silicide films respectively between and contacting the first electrode of each capacitor of the plurality of capacitors and a respective active region of the plurality of active regions,
   wherein each metal silicide film of the plurality of metal silicide films is respectively surrounded by an insulating loop of the plurality of insulating loops.

Each of the embodiments provided in the above description is not excluded from being associated with one or more features of another example or another embodiment also provided herein or not provided herein but consistent with the disclosure.

While the disclosure has been particularly shown and described with reference to embodiments thereof, it will be understood that various changes in form and details may be made therein without departing from the scope of the following claims.

## Claims

1. A semiconductor memory device comprising:
a substrate (102) having an upper surface (102M);
an active region (AC) spaced apart from the substrate in a vertical direction that is perpendicular to the upper surface (102M) of the substrate (102), and extending in a first lateral direction that is parallel to the upper surface (102M) of the substrate (102);
a word line (WL) at least partially surrounding the active region (AC) and extending in a second lateral direction that is parallel to the upper surface (102M) of the substrate (102) and perpendicular to the first lateral direction;
a capacitor (CAP) comprising a first electrode (186) connected to the active region (AC); and
an insulating loop (STL) protruding from the first electrode (186) of the capacitor (CAP) toward the word line (WL) in the first lateral direction, the insulating loop surrounding a portion of the active region (AC) and comprising a metal element.

2. The semiconductor memory device of claim 1, wherein the metal element comprises a crystallized metal oxide.

3. The semiconductor memory device of claim 1 or claim 2, wherein the capacitor further comprises a dielectric film (187) covering a surface of the first electrode (186), and
wherein the dielectric film (187) contacts the insulating loop (STL).

4. The semiconductor memory device of any preceding claim, wherein the capacitor (CAP) further comprises a dielectric film (187) covering a surface of the first electrode (186) and a second electrode (188) spaced apart from the first electrode (186) with the dielectric film (187) therebetween.

5. The semiconductor memory device of claim 4 wherein the dielectric film (187) comprises a metal element of a same type as the metal element of the insulating loop (STL).

6. The semiconductor memory device of claim 4 or claim 5, wherein the active region (AC) comprises a channel region (106A) at least partially surrounded by the word line (WL) and a buried contact (BC) between the first electrode (186) of the capacitor (CAP) and the channel region (106A),
wherein the semiconductor memory device further comprises:
an insulating liner (172) at least partially surrounding the buried contact (BC), the insulating liner (172) contacting a surface among surfaces of the insulating loop (STL) that is closest to the word line (WL) in the first lateral direction;
a buried insulating film (173) at least partially surrounding the insulating liner (172) and the insulating loop (STL); and
an oxide liner (174S) covering a surface of the buried insulating film (173) facing the dielectric film (187) and the second electrode (188),
wherein the oxide liner (174S) at least partially surrounds the insulating loop (STL), and
wherein the dielectric film (187) comprises a protrusion protruding toward the word line (WL) in the first lateral direction, the protrusion being between the oxide liner and the insulating loop (STL).

7. The semiconductor memory device of any of claims 4-6, wherein:
the first electrode (186) of the capacitor (CAP) has a cylindrical shape defining an inner space configured to accommodate a portion of the dielectric film (187) and a portion of the second electrode (188), and the dielectric film (187) covers an inner surface and an outer surface of the first electrode (186); or
the first electrode (186) of the capacitor (CAP) has a pillar shape with a filled interior, and the dielectric film (187) covers an outer surface of the first electrode (186).

8. The semiconductor memory device of any preceding claim, further comprising a metal silicide film (184) between the first electrode (186) of the capacitor (CAP) and the active region (AC), the metal silicide film (184) contacting each of the first electrode (186) and the active region (AC),
wherein the metal silicide film (184) is surrounded by the insulating loop (STL).

9. The semiconductor memory device of any preceding claim, further comprising a bit line (BL) extending in the vertical direction on the substrate (102) from the upper surface of the substrate (102), the bit line (BL) being connected to the active region (AC),
wherein the bit line (BL) is spaced apart from the capacitor (CAP) in the first lateral direction with the word line (WL) therebetween.

10. The semiconductor memory device of any preceding claim, further comprising a gate dielectric film (130) between the word line (WL) and the active region (AC),
wherein the gate dielectric film (130) is aligned and collinear with the insulating loop (STL) in the first lateral direction.

11. The semiconductor memory device of any preceding claim, the semiconductor memory device having a three-dimensional structure, the semiconductor memory device comprising:
a memory cell block on the substrate, the memory cell block comprising:
a plurality of active regions (AC) arranged in a line in the vertical direction
a plurality of word lines (WL), each word line (WL) of the plurality of word lines (WL) at least partially surrounding a respective active region (AC) of the plurality of active regions (AC) and extending in the second lateral direction;
a bit line (BL) extending in the vertical direction on the substrate (102), the bit line (BL) being connected to a first side of each active region (AC) of the plurality of active regions (AC);
a plurality of capacitors (CAP), each capacitor (CA) of the plurality of capacitors (CAP) comprising a first electrode (186) connected to a second side of a respective active region (AC) of the plurality of active regions (AC), the second side being opposite to the first side; and
a plurality of insulating loops (STL) arranged in a line in the vertical direction, each insulating loop (STL) of the plurality of insulating loops (STL) protruding from the first electrode (186) of a respective capacitor (CAP) of the plurality of capacitors (CAP) toward a corresponding word line (WL) of the plurality of word lines (WL) in the first lateral direction, each insulating loop (STL) of the plurality of insulating loops (STL) surrounding a portion of a respective active region (AC) of the plurality of active regions (AC),
wherein each insulating loop (STL) of the plurality of insulating loops (STL) comprises the metal element.

12. The semiconductor memory device of claim 11, wherein the plurality of insulating loops (STL) comprise a crystallized metal oxide.

13. The semiconductor memory device of claim 11 or claim 12, wherein each capacitor (CAP) of the plurality of capacitors further comprises a dielectric film (187) covering a surface of the first electrode (186).

14. The semiconductor memory device of claim 13, wherein:
the dielectric film (187) contacts at least one insulating loop (STL) of the plurality of insulating loops (STL); and/or
each of the dielectric film (187) and the plurality of insulating loops (STL) comprises a metal oxide.

15. The semiconductor memory device of any of claims 11-14, further comprising a plurality of metal silicide films (184) respectively between and contacting the first electrode (186) of each capacitor (CAP) of the plurality of capacitors (CAP) and a respective active region (AC) of the plurality of active regions (AC),
wherein each metal silicide film (184) of the plurality of metal silicide films (184) is respectively surrounded by an insulating loop (STL) of the plurality of insulating loops (STL).
